# EUROPEAN PATENT APPLICATION

(11) **EP 4 542 820 A1**
(43) Date of publication of application: **23.04.2025**
(21) Application number: 24201925.5
(22) Date of filing: 23.09.2024
(51) Int. Cl.: H02J 7/00, A45C 11/04, G02C 11/00, G02B 27/01

(54) **CHARGING CASE WITH RETENTION MECHANISM FOR RETAINING AND FACILITATING CHARGING OF SMART GLASSES VIA NOSE BRIDGE OF THE SMART GLASSES**

(30) Priority: 17.10.2023 US 202363591088 P; 31.07.2024 US 202418791341
(71) Applicant: Meta Platforms Technologies, LLC, Menlo Park, CA 94025 (US)
(72) Inventor: Pausal, Rolando Abella, Menlo Park (US); Bristol, Peter Wesley, Menlo Park (US); Ellis, Shane Michael, Menlo Park (US); Le Bihan, Inès, Menlo Park (US)
(74) Representative: Murgitroyd & Company

(57) **Abstract**

An example portable charging case for smart glasses comprises a glasses-retention portion of the charging case. The glasses-retention portion defines an interior surface of the portable charging case, and the glasses-retention portion is configured to apply a resistance force to securely hold smart glasses along the interior surface. The portable charging case also includes a retention bracket that is coupled with the glasses-retention portion. The retention bracket is configured to apply a force to the nose pad of the smart glasses to hold the smart glasses in place to facilitate stable charging between electrical contacts of the charging case and other electrical contacts on the nose pad of the smart glasses.

## Description

### RELATED APPLICATIONS

This claims benefit of, and the priority to, U.S. Provisional Application Sr. No. 63/591,088, entitled "Charging Case with Retention Mechanism for Retaining and Facilitating Charging of Smart Glasses Via Nose Bridge of Smart Glasses" filed October 17, 2023.

### TECHNICAL FIELD

This relates generally to a portable charging case that is configured to charge a pair of smart glasses (e.g., head-worn augmented-reality glasses) when they are secured into the portable charging case, including components configured ensure the pair of smart glasses remain in contact with charging contacts of the portable charging case.

### BACKGROUND

Traditional smart glasses need to be charged often due to their compact nature and high-power requirements. These constraints pose issues for users who wish to use the smart glasses in a public setting (i.e., not at home), as it becomes inconvenient to worry about looking for a power outlet in an unfamiliar location and then being tethered to that charging location for a significant period of time. Even if the device could be charged using a mobile battery charging bank, ensuring charging continues while the pair of glasses are moving can be problematic, as charging connections can become unconnected.

As such, there is a need to address one or more of the above-identified challenges. A brief summary of solutions to the issues noted above are described below.

### SUMMARY

The present invention provides a portable charging case for smart glasses as defined in the appended claims.

The example portable charging cases described herein address the issues noted above, including being able to charge a pair of smart glasses while out and ensuring that uninterrupted charging takes place while the pair of smart glasses are being charged within the portable charging case. Uninterrupted charging is ensured by one or more components described herein configured to hold the smart glasses in a position such that the charging contacts of the portable charging case remain in contact irrespective of orientation. In addition having a charging case that includes a battery that is configured to charge a battery of a pair of smart glasses is convenient, as the user can go longer between needing to plug the portable charging case into a power source.

In accordance with a first aspect, there is provided a portable charging case for smart glasses, the portable charging case comprising:
a glasses-retention portion of the portable charging case defining an interior surface of the portable charging case, wherein the glasses-retention portion is configured to apply a resistance force to securely hold smart glasses along the interior surface, and
a glasses-retention bracket, coupled with the glasses-retention portion, configured to apply a force to a nose pad of the smart glasses to hold the smart glasses in place to facilitate stable charging between electrical contacts of the portable charging case and other electrical contacts on the nose pad of the smart glasses.

The electrical contacts of the charging case may comprise pogo pins, wherein the pogo pins may be configured to maintain an electrical connection with the electrical contacts on the smart glasses.

The glasses-retention bracket may comprise a cylindrical bar.

The glasses-retention bracket may comprise a rounded rectangular surface.

The glasses-retention bracket may comprise a triangular surface.

The glasses-retention bracket may comprise one or more deployable portions configured to apply a resistance force to securely hold smart glasses along the interior surface.

The glasses-retention portion may comprise a portion of the portable charging case that is configured to deflect, and upon deflection applies the resistance force to securely hold the smart glasses.

The glasses-retention portion may comprise a coil spring.

The glasses-retention portion may comprise a torsion spring.

The glasses-retention portion may comprise a leaf spring.

The leaf spring may be made of a sheet metal material.

The leaf spring may be made of a polymer material.

The leaf spring may comprise a magnet configured to adjust a bending force of the leaf spring.

The leaf spring may have a non-linear shape along an axis.

The leaf spring may have a non-linear shape along another axis.

The portable charging case may comprise a release mechanism configured to release the smart glasses from the charging case.

The glasses-retention portion and the retention bracket may be coupled together.

The glasses-retention portion may comprise a separate structure and not integrally formed with rest of the portable charging case.

The charging case may comprise a battery that is configured to charge another battery located within the smart glasses, wherein the battery is configured to charge the other battery at least once.

The portable charging case may comprise an exterior surface, said exterior surface having a laminated cosmetic covering.

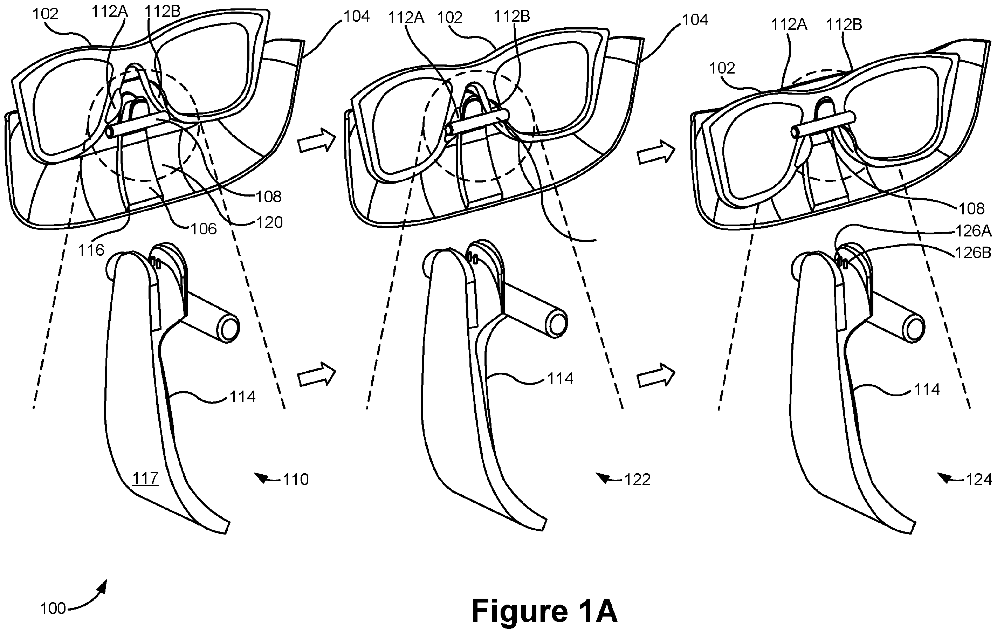

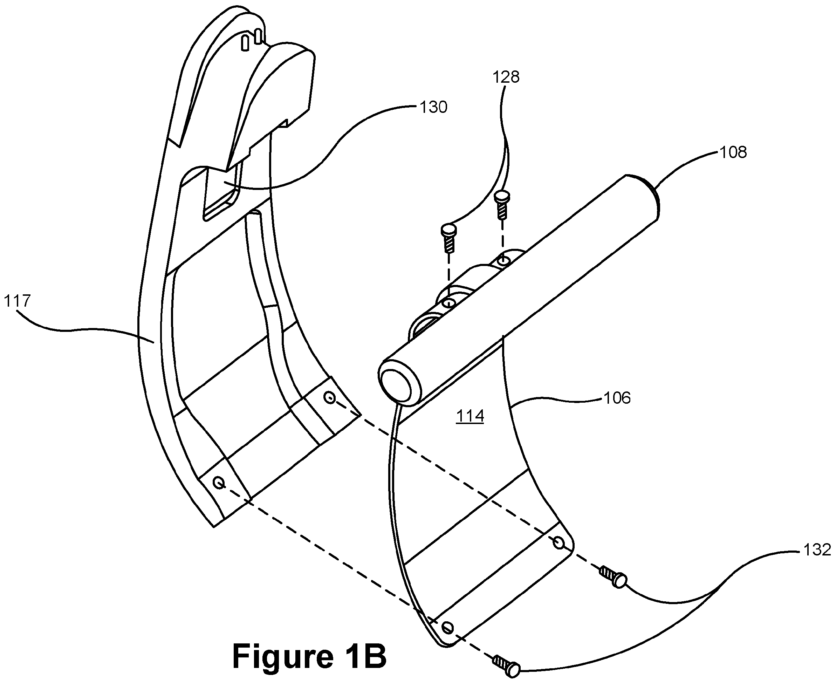

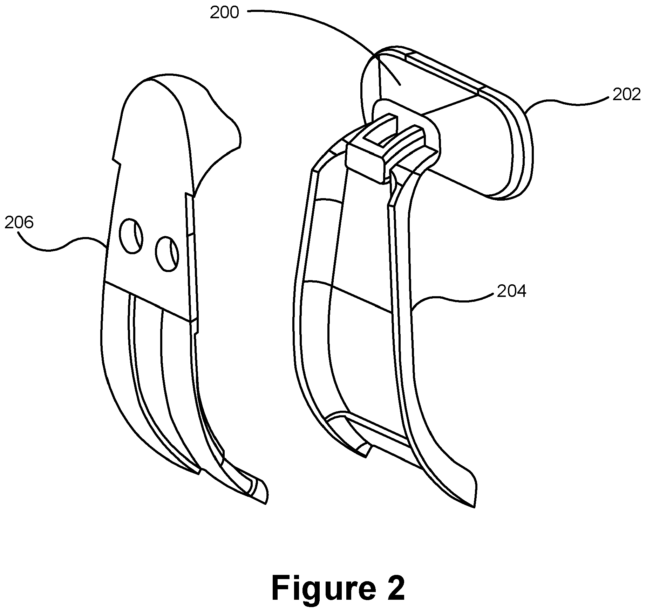

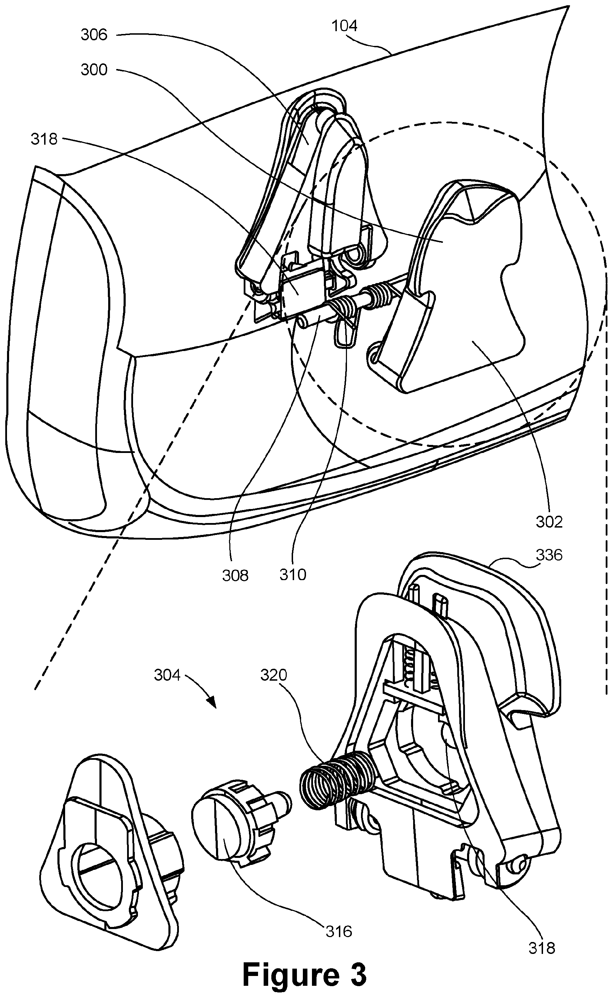

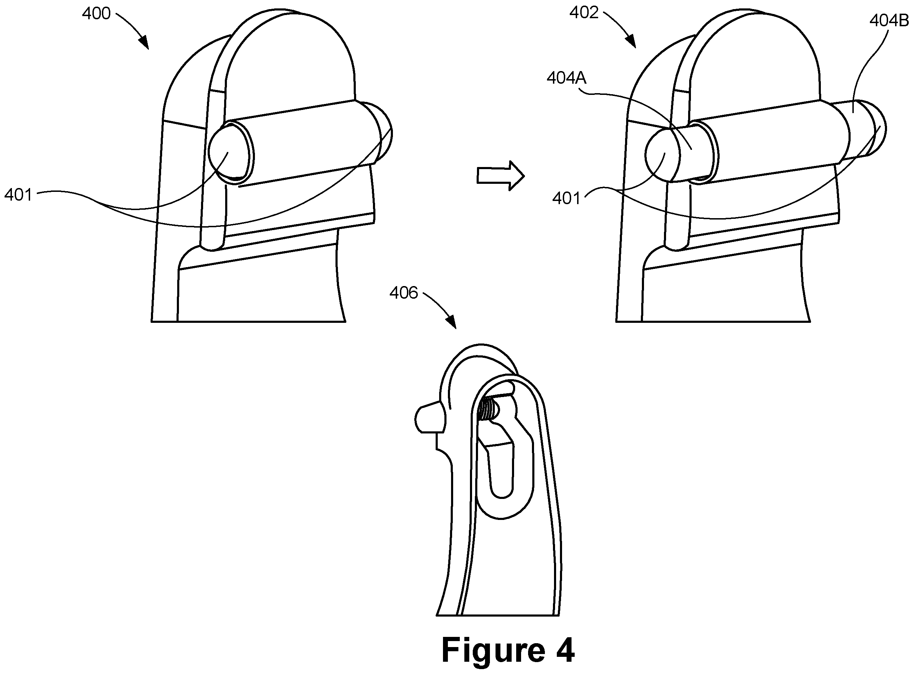

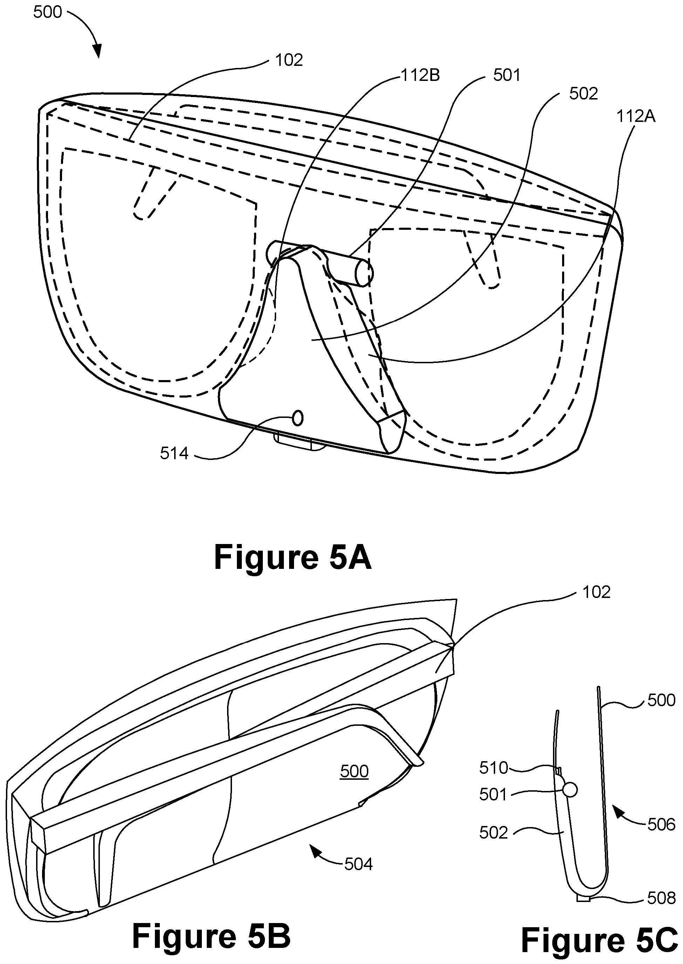

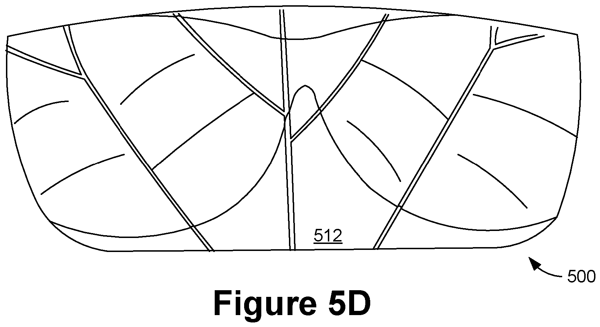

One example of a portable charging case (e.g., portable charging case described in reference in any of Figures 1A-5) for smart glasses (e.g., a smart-glasses case that largely mirrors the appearance and shape of a traditional glasses case) comprises, a glasses-retention portion (e.g., Figure 1 illustrates the glasses retention portion 106 has a shape that follows a contour of an interior surface 120 of the charging case) of the charging case defining a contour along an interior surface of the portable charging case (e.g., a leaf spring component, or a component that includes a spring (e.g., a leaf spring, a torsion spring, a coil spring, etc.)). The glasses-retention portion is configured to apply a resistance force to securely hold smart glasses (e.g., smart glasses 104 described in reference to Figures 1A-5) along the contour. In some embodiments, the glasses retention portion is the portable charging case, such that a material constructing the case is configured to apply a resistance force, by being able to deflect, to securely hold smart glasses along the contour. In this embodiment, fewer components are needed and the case can be made smaller. The portable charging case also includes a retention bracket (e.g., Figures 1A-1B illustrate glasses retention bracket 108, Figure 2 illustrates a glasses retention bracket 200, Figure 3 illustrates a glasses retention bracket 300, Figure 4 illustrates a deployable mechanism 401 that is a retention bracket, and Figure 5 illustrates a retention bracket 501), coupled with the glasses-retention portion (e.g., Figures 1A- 1B illustrate a glasses retention portion 106, Figure 2 illustrates glasses retention portion 204, Figure 3 illustrates glasses retention portion 302, Figure 4, and Figure 5 illustrates a glasses-retention portion 502 that can include an exterior/interior protective surface of the portable charging case 500), configured to apply a force to the nose pad (e.g., nose pads 112A and 112B described in reference to Figures 1A-5) of the smart glasses to hold the smart glasses in place to facilitate stable charging between electrical contacts of the charging case (e.g., charging contacts 126A and 126B shown in Figure 1) and other electrical contacts on the nose pad of the smart glasses. In some embodiments, the retention bracket is configured to match a detent on the smart glasses, such that when the smart glasses are fully inserted, the retention bracket rests in the detent, ensuring less movement occurs while the smart glasses are fully inserted.

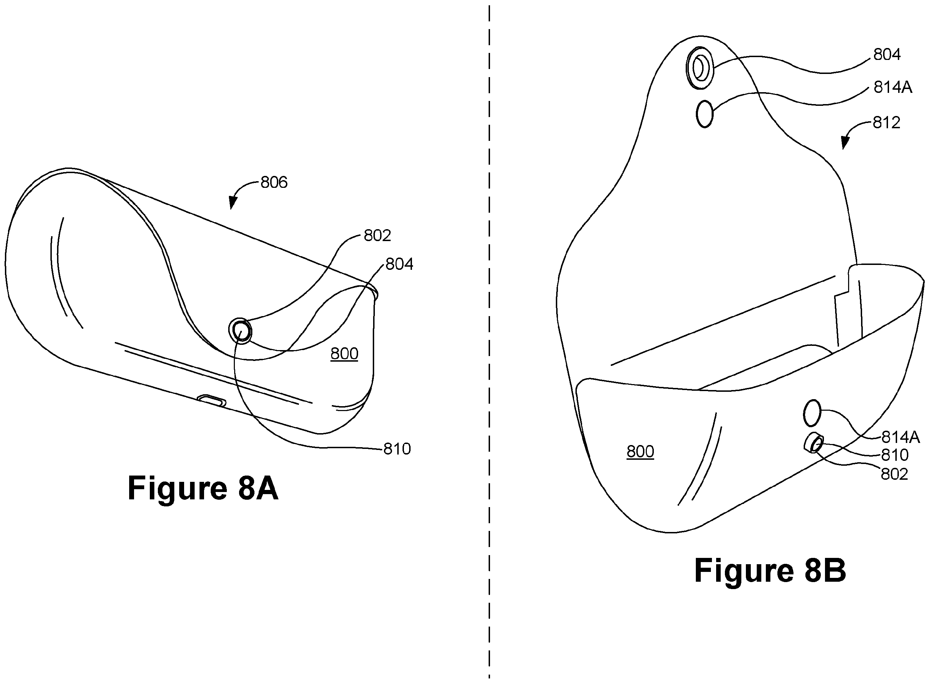

In another example embodiment, a portable charging case for smart glasses comprises a cavity configured to house a pair of smart glasses. The portable charging case also comprises a lid configured to enclose the cavity, and a clasp that attaches the lid to another portion of the portable charging case. The portable charging case also comprises a light integrated into a portion of the clasp that is attached the other portion of the portable charging case, and the light ring is configured to provide (i) a charging status information of the portable charging case, and (ii) a charging status information for a pair of smart glasses inserted into the cavity. Charging status information can indicate whether the case is charged, case is charging, glasses are charged, glasses are charging, or a combination of charging statuses. For example, Figures 8A-9 illustrate a portable charging case that includes a clasp with an integrated light that indicates charging statuses of portable charging case and the a pair of smart glasses enclosed within the charging case.

The features and advantages described in the specification are not necessarily all inclusive and, in particular, certain additional features and advantages will be apparent to one of ordinary skill in the art in view of the drawings, specification, and claims. Moreover, it should be noted that the language used in the specification has been principally selected for readability and instructional purposes.

It will be appreciated that any features described herein as being suitable for incorporation into one or more aspects are intended to be generalizable across any and all aspects described herein. Other aspects can be understood by those skilled in the art in light of the description, the claims and the drawings. The foregoing general description and the following detailed description are exemplary and explanatory only and are not restrictive of the claims.

Having summarized the above example aspects, a brief description of the drawings will now be presented.

### BRIEF DESCRIPTION OF THE DRAWINGS

For a better understanding of the various described embodiments, reference should be made to the Detailed Description below, in conjunction with the following drawings in which like reference numerals refer to corresponding parts throughout the figures.
Figures 1A and 1B illustrate components for a portable charging case that is configured to charge smart glasses, in accordance with some embodiments.
Figure 2 illustrates an alternative embodiment where a glasses retention bracket 200 has a rounded rectangular surface, in accordance with some embodiments.
Figure 3 illustrates another glasses retention bracket, a glasses retention portion, and a release mechanism that is configured to eject smart glasses, in accordance with some embodiments.
Figure 4 shows another embodiment for a glasses retention bracket and a glasses retention portion, where the glasses retention bracket includes a deployable mechanism configured to hold smart glasses within a portable charging case, in accordance with some embodiments.
Figure 5A-5D illustrates another embodiment where a retention bracket and a glasses retention portion are coupled to a portable charging case, such that the glasses retention portion does not move relative to the portable charging case, in accordance with some embodiments.
Figures 6A and 6B illustrate example artificial-reality systems, in accordance with some embodiments.
Figures 7A, 7B-1, 7B-2, and 7C illustrate example head-wearable devices, in accordance with some embodiments.
Figures 8A-8B illustrates a portable charging case 800 that includes an LED ring 802 that is integrated with a clasp 804 of the portable charging case 800, in accordance with some embodiments.
Figure 9 illustrates a cutaway view of the LED ring shown in Figures 8A and 8B, in accordance with some embodiments.
Figure 10 illustrates fixed locations on a pair of smart glasses, such that smart glasses of other designs while maintaining these points can interface with the portable charging case, in accordance with some embodiments.
Figure 11 illustrates an example nose bridge that includes two pogo pins for transferring a charge to a pair of smart glasses, where the nose bridge includes techniques for minimizing issues related to corrosion, in accordance with some embodiments.

In accordance with common practice, the various features illustrated in the drawings may not be drawn to scale. Accordingly, the dimensions of the various features may be arbitrarily expanded or reduced for clarity. In addition, some of the drawings may not depict all of the components of a given system, method, or device. Finally, like reference numerals may be used to denote like features throughout the specification and figures.

### DETAILED DESCRIPTION

Numerous details are described herein to provide a thorough understanding of the example embodiments illustrated in the accompanying drawings. However, some embodiments may be practiced without many of the specific details, and the scope of the claims is only limited by those features and aspects specifically recited in the claims. Furthermore, well-known processes, components, and materials have not necessarily been described in exhaustive detail so as to avoid obscuring pertinent aspects of the embodiments described herein.

Embodiments of this disclosure can include or be implemented in conjunction with various types or embodiments of artificial-reality systems. Artificial-reality (AR), as described herein, is any superimposed functionality and or sensory-detectable presentation provided by an artificial-reality system within a user's physical surroundings. Such artificial-realities can include and/or represent virtual reality (VR), augmented reality, mixed artificial-reality (MAR), or some combination and/or variation one of these. For example, a user can perform a swiping in-air hand gesture to cause a song to be skipped by a song-providing API providing playback at, for example, a home speaker. An AR environment, as described herein, includes, but is not limited to, VR environments (including non-immersive, semi-immersive, and fully immersive VR environments); augmented-reality environments (including marker-based augmented-reality environments, markerless augmented-reality environments, location-based augmented-reality environments, and projection-based augmented-reality environments); hybrid reality; and other types of mixed-reality environments.

Artificial-reality content can include completely generated content or generated content combined with captured (e.g., real-world) content. The artificial-reality content can include video, audio, haptic events, or some combination thereof, any of which can be presented in a single channel or in multiple channels (such as stereo video that produces a three-dimensional effect to a viewer). Additionally, in some embodiments, artificial reality can also be associated with applications, products, accessories, services, or some combination thereof, which are used, for example, to create content in an artificial reality and/or are otherwise used in (e.g., to perform activities in) an artificial reality.

A hand gesture, as described herein, can include an in-air gesture, a surface-contact gesture, and or other gestures that can be detected and determined based on movements of a single hand (e.g., a one-handed gesture performed with a user's hand that is detected by one or more sensors of a wearable device (e.g., electromyography (EMG) and/or inertial measurement units (IMU)s of a wrist-wearable device) and/or detected via image data captured by an imaging device of a wearable device (e.g., a camera of a head-wearable device)) or a combination of the user's hands. In-air means, in some embodiments, that the user hand does not contact a surface, object, or portion of an electronic device (e.g., a head-wearable device or other communicatively coupled device, such as the wrist-wearable device), in other words the gesture is performed in open air in 3D space and without contacting a surface, an object, or an electronic device. Surface-contact gestures (contacts at a surface, object, body part of the user, or electronic device) more generally are also contemplated in which a contact (or an intention to contact) is detected at a surface (e.g., a single or double finger tap on a table, on a user's hand or another finger, on the user's leg, a couch, a steering wheel, etc.). The different hand gestures disclosed herein can be detected using image data and/or sensor data (e.g., neuromuscular signals sensed by one or more biopotential sensors (e.g., EMG sensors) or other types of data from other sensors, such as proximity sensors, time-of-flight (ToF) sensors, sensors of an inertial measurement unit, etc.) detected by a wearable device worn by the user and/or other electronic devices in the user's possession (e.g., smartphones, laptops, imaging devices, intermediary devices, and/or other devices described herein).

As described herein, a portable charging case that is configured to protect and charge a pair of smart glasses, similar to those described above, will be discussed in detail. Figures 1A and 1B illustrate components for a portable charging case that is configured to charge smart glasses, in accordance with some embodiments. Figure 1A shows a series 100 illustrating inserting smart glasses 102 into a portable charging case 104. Figure 1A also shows how a glasses retention portion 106 and a glasses retention bracket 108 operate together to ensure the smart glasses 102 are retained in the portable charging case for charging.

A first step 110 of the sequence is shown, where the smart glasses 102 are just starting to be inserted into the portable charging case 104. As shown in the first step 110, glasses retention bracket 108 has a cylindrical shape, and the cylindrical shape is configured such that it can move along the nose pads 112A and 112B of the smart glasses.

In order for the retention bracket 108 to move along the nose pads 112A and 112B, the glasses retention bracket 108 is coupled to a glasses retention portion 106 that is at least partially configured to bend. For example, the glasses retention portion 106 is a leaf spring 114 that is coupled at one end 116 to the charging case (or intermediary component 117 that is coupled to the charging case), and the other end 118 is coupled to the glasses retention bracket 108. In some embodiments, the glasses retention portion 106 has a shape that follows a contour of an interior surface 120 of the charging case.

A second step 122 of the sequence is shown, where the smart glasses 102 are partially inserted into the portable charging case 104. As shown in second step 122, the nose pads 112A and 112B moving along the retention bracket 108 and ultimately causing the glasses retention portion 106 (e.g., a leaf spring 114) to deflect (e.g., bend).

Third step 124 illustrates that the smart glasses 102 are fully inserted into the portable charging case 104. As shown in third step 124, the nose pads 112A and 112B are no longer pushing against the glasses retention bracket 108 and the glasses retention portion 106 (e.g., the leaf spring 114) ends up returning to its resting state. In some embodiments, the resting state includes at least some preload on the leaf spring to ensure a predefined resistance force is maintained. Once the smart glasses 102 are fully inserted, a charging pad on the smart glasses 102 make contact with case-charging contacts 126A and 126B which can be spring loaded charging contacts that are configured to charge the smart glasses 102. The glasses retention bracket 108, in conjunction with spring loaded contacts and the retention bracket 108, the portable charging case 104 can continuously charge the smart glasses 102 in any orientation. The nose pads have a shape such that when fully inserted, the glasses retention bracket is in contact with the nose pads and the glasses portion is in its undeflected state.

Figure 1B illustrates an exploded view of glasses retention bracket 108 and glasses retention portion 106 that includes intermediary component 117, in accordance with some embodiments. Figure 1B illustrates that the glasses retention bracket 108 is coupled to the glasses retention portion 106 via one or more fasteners 128. In some embodiments, the glasses retention bracket 108 and the glasses retention portion 106 are integrally formed with each other. Figure 1B also shows that the glasses retention portion 106 is coupled to the intermediary portion 117 via one or more additional fasteners 132. In some embodiments, intermediary portion 117 includes a cavity 128 that is configured to house one or more electrical components for charging the smart glasses 102. In some embodiments, the intermediary portion 117 includes a magnet 130 configured to further control the movement of the glasses retention portion 106 (e.g., by controlling the movement of the leaf spring, where a portion of the leaf spring 114 is made of a ferrous material. In some embodiments, the magnet 130 is coupled to the leaf spring 114 and the intermediary portion 117 is made of a ferrous material.

Figure 2 illustrates an alternative embodiment where a glasses retention bracket 200 has a rounded rectangular surface 202, in accordance with some embodiments. In some embodiments, the rounded rectangular surface 202 is selected to control the haptic sensation felt at the smart glasses 102 when inserting the smart glasses 102 into the portable charging case 104 (not pictured). Figure 2 also illustrates a glasses retention portion 204 that is coupled with the glasses retention bracket 200. In this example, the glasses retention portion 204 itself is not a leaf spring, and can be made of the same material as the glasses retention bracket 200. In this example, the glasses retention bracket can include a coil spring or torsion spring (not pictured, see Figure 3 as an example torsion spring) to control the movement of the glasses retention bracket 200 while the smart glasses 102 are being inserted into a charging case. Figure 2 also illustrates another intermediary portion 206 that can be configured to work in conjunction with the coil spring shown in Figure 3.

Figure 3 illustrates another glasses retention bracket 300, a glasses retention portion 302, and a release mechanism 304 that is configured to eject smart glasses 102, in accordance with some embodiments. Figure 3 shows that an intermediary portion 306 is coupled with a glasses charging case 300, and the glasses retention portion 302 is coupled via hinge 308 to the intermediary portion 306. The hinge 308 includes a torsion spring 310 that is configured to control the movement (e.g., rotation of the glasses retention portion 302 about the hinge 308) of the glasses retention portion 302 relative to the intermediary portion 306. Figure 3 illustrates that the glasses retention portion 302 is coupled to a glasses retention bracket 312, and the glasses retention bracket 312 has a triangular surface 314. In some embodiments, the torsion spring is configured to keep the surface of the glasses retention portion 302 in contact with the intermediary portion 306 in its resting state. In some embodiments, the resting state does include the torsion spring having a preload ensuring that the smart glasses remain in place after being inserted.

Figure 3 further illustrates a release mechanism 304 that is configured to eject the smart glasses 102 from the portable charging case 104. The release mechanism can be activated via a button 316 that is placed on an exterior portion of the portable charging case 104. In some embodiments, the release mechanism is configured to push a portion 316 against a portion 318, via a coil spring 320 or another component, of the torsion spring 310 to cause rotation of the glasses retention portion 302, which results in the smart glasses 102 being ejected and/or made easier to remove from the portable charging case 104. The release mechanism can be configured to work with the other embodiments described.

Figure 3 also illustrates that the charging contacts 332A and 332B are held in place at least partially by springs 334A and 334B, respectively, and the springs ensure charging contacts 332A and 332B remain in contact with electrical contacts on the nose bridge of the smart glasses 102. Figure 3 also illustrates that glasses retention bracket 312 has a triangular surface 336.

Figure 4 shows another embodiment for a glasses retention bracket and a glasses retention portion, where the glasses retention bracket includes a deployable mechanism configured to hold smart glasses within a portable charging case, in accordance with some embodiments. Figure 4 shows that in a first pane 400 the deployable mechanism 401 is in its undeployed state (e.g., two spring loaded posts 404A and 404B in an extended state), and second pane 402 shows the deployment mechanism 401 in its deployed state (e.g., two spring loaded posts 404A and 404B in an nonextended state). A back side view 406 is shown to illustrate the deployment mechanism 401, and how it is spring loaded via spring 406. In some embodiments, multiple springs can be used. The deployment mechanism 401 is configured such that the deployed state shown in second pane 402 when the smart glasses 102 are fully inserted into the portable charging case 104, such that the smart glasses are held in place by the two spring loaded posts 404A and 404B.

Figure 5A illustrates another embodiment where a retention bracket 501 and a glasses-retention portion 502 are coupled to a portable charging case 500, such that the glasses-retention portion 502 does not move relative to the portable charging case 500, in accordance with some embodiments. In this example, the deflection that is shown in the earlier described examples, instead occurs at the portable charging case, e.g., the material portable charging case acts as a spring (e.g., by having a flexible center portion (e.g., a polymer shell (e.g., a polycarbonate shell, ABS shell, etc.), a composite (e.g., polycarbonate with glass fibers), etc.). The portable charging case acts as a spring when it is constructed of a material that is able to elastically deform while the smart glasses 102 are being inserted the portable charging case 500. In other words, the portable charging case deflects when nose pads 112A and 112B pass over the retention bracket 501. After the nose pads 112A and 112B pass over the retention bracket 501, the portable charging case 500 returns to its undeflected state. When the portable charging case 500 is in its undeflected state the charging case provides enough pressure to keep the smart glasses in contact with charging contacts, while the portable charging case 500 is in any physical orientation (e.g., sideways, upside down etc.). In some embodiments, portable charging case 500 is produced in part or entirely using a variation of materials to produce a desired texture and/or to rely on sustainable materials. In some embodiments, the exterior of the portable charging case is made of entirely sustainable materials or a sustainable material is a layer that provides a desired cosmetic finish (e.g., a finish using natural materials, recycled materials, etc.). In some embodiments, the material selected can be used to further control the amount of elastic deformation that occurs when inserting and removing the smart glasses 102. In some embodiments, the portable charging case 500 does not include a battery for mobile charging, and is used as a traditional glasses holder, but also configured to charge the smart glasses when a charger is plugged into the portable charging case 500. By having the charging connector built into the case, charging contacts can be used on the smart glasses instead of a large traditional connector (e.g., USB type-c port) in order to better control the size of the smart glasses. In some embodiments, the portable charging case 500 does include a battery for mobile charging (i.e., charging while not plugged into a constant power source (e.g., a wall socket)).

Figure 5A also illustrates that the portable charging case includes an indicator light 514 (e.g., a multicolor LED) that is configured to light up to convey different charging states of the portable charging case (e.g., indicating that the case has a charge level above or below a threshold state of charge (e.g., 20% or a battery capacity that is configured to be able to provide a full charge to the smart glasses), indicating that the case is being charged, indicating a charge level of the battery located in the smart glasses contained within the case, etc.).

Figure 5B illustrates a back side 504 of portable charging case 500, in accordance with some embodiments. Figure 5B shows that the portable charging case, in this embodiments, does not completely encase the smart glasses 102. For example, the portable charging case is configured to cover sensitive portions of the smart glasses (e.g., the lenses and electrical components located within the nose bridge). In some embodiments, the portable charging case of Figures 5A-5D are configured to cover the entirety of the smart glasses 102.

Figure 5C illustrates a cutaway view 506 of the portable charging case 500 that is shown in Figures 5A-5B, in accordance with some embodiments. Figure 5C shows that the retention bracket 501 and a glasses-retention portion 502 can be permanently formed with the portable charging case. In some embodiments, the retention bracket 501 is directly attached and in contact with the portable charging case 500 (i.e., not attached to the glasses-retention portion 502). Figure 5C shows that the portable charging case 500 can include a charging port 508 (e.g., a USB type-c port), and that the portable charging case 500 is configured to receive power and transfer said power to one or more pogo pins 510 for contacting smart glasses 102.

Figure 5D shows that a cosmetic cover can be placed on the portable charging case 500, in accordance with some embodiments. Figure 5D shows a cosmetic exterior 512 of the portable charging case, which can be attached e.g., via lamination. In this example, the cosmetic exterior 512 is made from natural materials (e.g., a tree leaf) and has a design corresponding to tree leaves. In some embodiments, the cosmetic portion only covers the outside (e.g., surfaces not in contact with lenses of the smart glasses), but in other embodiments it is also found on at least one interior surface (e.g., surfaces in contact with lenses of the smart glasses) of the portable charging case 500. In some embodiments, the interior material is a microfiber or a synthetic suede, such that the lenses of the smart glasses do not get damaged from contact with the charging case 500 when being inserted and removed. In some embodiments, the interior material is configured to cover at least a portion of the glasses-retention portion 502, such that the interior appears seamless when fully assembled. In some embodiments, the exterior material can be synthetic leather, natural leather, a woven or knit material, a plastic material, and/or sustainable materials (e.g., recycled plastic derived materials, organic materials (e.g., bamboo), etc.). The cosmetic covers described above are equally applicable to the other portable charging cases described in reference to Figures 1A-4. In some embodiments, a single pair of smart glasses can be configured to work with any of the charging cases described above, for example, a user may use a portable charging case that includes a portable battery if the user anticipates being away from a charger for an extended period, or the user can may use a portable charging case that does not include a portable battery when the user wants to use a lighter carrying case.

(A1) In accordance with some embodiments, a portable charging case (e.g., portable charging case described in reference in any of Figures 1A-5D) for smart glasses (e.g., a smart-glasses case that largely mirrors the appearance and shape of a traditional glasses case) comprises a glasses-retention portion (e.g., Figure 1 illustrates the glasses retention portion 106 has a shape that follows a contour of an interior surface 120 of the charging case) of the charging case defining a contour along an interior surface of the portable charging case (e.g., a leaf spring component, or a component that includes a spring (e.g., a leaf spring, a torsion spring, a coil spring, etc.)), wherein the glasses-retention portion is configured to apply a resistance force to securely hold smart glasses (e.g., smart glasses 104 described in reference to Figures 1A-5D) along the contour, and In some embodiments, the glasses retention portion is the portable charging case, such that a material constructing the case is configured to apply a resistance force, by being able to deflect, to securely hold smart glasses along the contour. In this embodiment, fewer components are needed and the case can be made smaller. The portable charging case also includes a retention bracket (e.g., Figures 1A-1B illustrate glasses retention bracket 108, Figure 2 illustrates a glasses retention bracket 200, Figure 3 illustrates a glasses retention bracket 300, Figure 4 illustrates a deployable mechanism 401 that is a retention bracket, and Figure 5A illustrates a retention bracket 501), coupled with the glasses-retention portion (e.g., Figures 1A-1B illustrate a glasses retention portion 106, Figure 2 illustrates glasses retention portion 204, Figure 3 illustrates glasses retention portion 302, Figure 4, and Figure 5A illustrates a glasses-retention portion 502 that can include an exterior/interior protective surface of the portable charging case 500), configured to apply a force to the nose pad (e.g., nose pads 112A and 112B described in reference to Figures 1A-5D) of the smart glasses to hold the smart glasses in place to facilitate stable charging between electrical contacts of the charging case (e.g., charging contacts 126A and 126B shown in Figure 1) and other electrical contacts on the nose pad of the smart glasses. In some embodiments, the retention bracket is configured to match a detent on the smart glasses, such that when the smart glasses are fully inserted, the retention bracket rests in the detent, ensuring less movement occurs while the smart glasses are fully inserted.

(A2) In some embodiments of A1, the electrical contacts of the charging case are pogo pins (e.g., electrical contacts coupled to a spring to push the electrical contacts into the electrical contacts of the smart glasses, i.e., making charging consistent regardless of spatial orientation of the charging case and the smart glasses). In some embodiments, the pogo pins are configured to maintain an electrical connection with the electrical contacts on the smart glasses (e.g., on the nose pads or on a nose bridge of the smart glasses) for charging (e.g., charging a battery of the smart glasses via another battery located within the charging case). For example, Figure 3 illustrates that the charging contacts 332A and 332B being held in place at least partially by springs 334A and 334B, respectively, and the springs ensure charging contacts 332A and 332B remain in contact with electrical contacts on the nose bridge of the smart glasses 102.

(A3) In some embodiments of any of A1-A2, the glasses-retention bracket is a cylindrical bar (e.g., where the cylindrical bar is configured to run along the contours of the nose pad of the smart glasses). For example, Figures 1A-1B both illustrate a glasses retention bracket 108 that has a cylindrical shape.

(A4) In some embodiments of any of A1-A2, the glasses-retention bracket has a rounded rectangular surface (e.g., where the rounded rectangular surface is configured to run along the contours of the nose pad of the smart glasses). Figure 2 illustrates that the glasses-retention bracket 200 has a rounded rectangular surface 202.

(A5) In some embodiments of any of A1-A2, the glasses-retention bracket has a triangular surface (e.g., where the rounded rectangular surface conforms to a shape of the nose pad and a nose bridge of the smart glasses). Figure 3 also illustrates that glasses retention bracket 312 has a triangular surface 336.

(A6) In some embodiments of any of A1-A5, the glasses-retention bracket includes one or more deployable portions configured to apply a resistance force to securely hold smart glasses along the contour. Figure 4 illustrates an example glasses-retention bracket that includes a deployable mechanism 401.

(A7) In some embodiments of any of A1-A6, the glasses-retention portion includes a portion of the portable charging case that is configured to deflect, and upon deflection applies the resistance force to securely hold the smart glasses. For example, Figures 1A-1B illustrate a leaf spring 114 that is configured to deflect as the smart glasses 102 are being inserted in the charging case 104.

(A8) In some embodiments of any of A1-A7, the glasses-retention portion includes a coil spring.

(A9) In some embodiments of any of A1-A8, the glasses-retention portion includes a torsion spring. For example, Figure 3 illustrates a torsion spring 310.

(A10) In some embodiments of any of A1-A9, the glasses-retention portion includes a leaf spring (e.g., leaf spring 114 shown in Figures 1A-1B).

(A11) In some embodiments of A10, the leaf spring is made of a sheet metal material (e.g., stamped steel, aluminum, magnesium, etc.).

(A12) In some embodiments of A10, the leaf spring is made of a polymer material.

(A13) In some embodiments of A10, the leaf spring includes a magnet configured to adjust a bending force of the leaf spring. For example, Figure 1B illustrates a magnet 130 configured to adjust the force required to insert the smart glasses into the portable charging case.

(A14) In some embodiments of any of A9-A13, the leaf spring has a non-linear shape along an axis. For example, leaf spring 114 shown in Figure 1B tapers towards the edge that connects to the glasses retention bracket 108. In some embodiments, the non-linear shape is configured to adjust and tune the force required to insert the smart glasses into the portable charging case.

(A15) In some embodiments of A14, the leaf spring has a non-linear shape along another axis. For example, leaf spring 114 shown in Figure 1B curves along an axis. In some embodiments, the non-linear shape is configured to adjust and tune the force required to insert the smart glasses into the portable charging case.

(A16) In some embodiments of any of A1-A15, a release mechanism configured to release the smart glasses from the charging case. For example, Figure 3 shows an example release mechanism 304 that is configured to release or partially eject the smart glasses from the charging case.

(A17) In some embodiments of any of A1-A16, the glasses-retention portion and the retention bracket are coupled together. For example, Figures 2 and 3 both show a glasses retention bracket integrally formed with a glasses retention portion.

(A18) In some embodiments of any of A1-A17, the glasses-retention portion is a separate structure and not integrally formed with rest of the case. For example, Figure 1B illustrates that glasses retention portion 106 is separate from the rest of the portable charging case. In some embodiments, the glasses-retention portion is not a separate structure and is integrally formed with rest of the portable charging case.

(A19) In some embodiments of any of A1-A18, the charging case includes a battery that is configured to charge another battery located within the smart glasses, wherein the battery is configured to charge the other battery at least once.

(A20) In some embodiments of any of A1-A19, an exterior surface of the portable charging case has a laminated cosmetic covering.

(A21) In some embodiments of any of A1-A20, the portable charging case includes an indicator light that indicates the charge status of the portable charging case and/or the charge status of the smart glasses.

(A22) In some embodiments of A21, the locations in which the indicator light emits light is controlled by using a non-translucent plastic material (e.g., dark plastic does not emit light through it and translucent plastic allows for light to pass through).

(A23) In some embodiments, of A22, the non-translucent plastic material includes 1-5% of titanium dioxide to reduce the amount of light bleed.

(B1) In accordance with some embodiments, smart glasses configured to fit in a portable charging case comprise, a nose pad of the smart glasses that is configured to interface with a glasses-retention portion of a charging case. The glasses-retention portion defines a contour along an interior surface of the portable charging case. The glasses-retention portion is configured to apply a resistance force to securely hold the smart glasses along the contour. A retention bracket of the portable charging case is coupled with the glasses-retention portion, configured to apply a force to the nose pad of the smart glasses to hold the smart glasses in place to facilitate stable charging between electrical contacts of the charging case and other electrical contacts on the nose pad of the smart glasses.

(B2) In some embodiments of B1, the smart glasses and the portable charging case are configured in accordance with any of A1-A23.

(C1) In accordance with some embodiments, a portable charging system that includes portable charging case that is configured for use with at least two pair of smart glasses, where a first pair of smart glasses of the at least two pair of smart glasses have a first shape and a second pair of smart glasses of the at least two pair of smart glasses have a second shape, and the first shape is different from the second shape. The first pair of smart glasses and the second pair of smart glasses each include respective fixed regions that are configured to interface with the portable charging case. The respective fixed regions between the first pair of smart glasses and the second pair of smart glasses are the same.

The devices described above are further detailed below, including systems, wrist-wearable devices, headset devices, and smart textile-based garments. Specific operations described above may occur as a result of specific hardware, such hardware is described in further detail below. The devices described below are not limiting and features on these devices can be removed or additional features can be added to these devices. The different devices can include one or more analogous hardware components. For brevity, analogous devices and components are described below. Any differences in the devices and components are described below in their respective sections.

As described herein, a processor (e.g., a central processing unit (CPU) or microcontroller unit (MCU)), is an electronic component that is responsible for executing instructions and controlling the operation of an electronic device (e.g., a wrist-wearable device 603, a head-wearable device, an HIPD 607, a smart textile-based garment, or other computer system). There are various types of processors that may be used interchangeably or specifically required by embodiments described herein. For example, a processor may be (i) a general processor designed to perform a wide range of tasks, such as running software applications, managing operating systems, and performing arithmetic and logical operations; (ii) a microcontroller designed for specific tasks such as controlling electronic devices, sensors, and motors; (iii) a graphics processing unit (GPU) designed to accelerate the creation and rendering of images, videos, and animations (e.g., virtual-reality animations, such as three-dimensional modeling); (iv) a field-programmable gate array (FPGA) that can be programmed and reconfigured after manufacturing and/or customized to perform specific tasks, such as signal processing, cryptography, and machine learning; (v) a digital signal processor (DSP) designed to perform mathematical operations on signals such as audio, video, and radio waves. One of skill in the art will understand that one or more processors of one or more electronic devices may be used in various embodiments described herein.

As described herein, controllers are electronic components that manage and coordinate the operation of other components within an electronic device (e.g., controlling inputs, processing data, and/or generating outputs). Examples of controllers can include (i) microcontrollers, including small, low-power controllers that are commonly used in embedded systems and Internet of Things (IoT) devices; (ii) programmable logic controllers (PLCs) that may be configured to be used in industrial automation systems to control and monitor manufacturing processes; (iii) system-on-a-chip (SoC) controllers that integrate multiple components such as processors, memory, I/O interfaces, and other peripherals into a single chip; and/or DSPs. As described herein, a graphics module is a component or software module that is designed to handle graphical operations and/or processes, and can include a hardware module and/or a software module.

As described herein, memory refers to electronic components in a computer or electronic device that store data and instructions for the processor to access and manipulate. The devices described herein can include volatile and non-volatile memory. Examples of memory can include (i) random access memory (RAM), such as DRAM, SRAM, DDR RAM or other random access solid state memory devices, configured to store data and instructions temporarily; (ii) read-only memory (ROM) configured to store data and instructions permanently (e.g., one or more portions of system firmware and/or boot loaders); (iii) flash memory, magnetic disk storage devices, optical disk storage devices, other non-volatile solid state storage devices, which can be configured to store data in electronic devices (e.g., universal serial bus (USB) drives, memory cards, and/or solid-state drives (SSDs)); and (iv) cache memory configured to temporarily store frequently accessed data and instructions. Memory, as described herein, can include structured data (e.g., SQL databases, MongoDB databases, GraphQL data, or JSON data). Other examples of memory can include: (i) profile data, including user account data, user settings, and/or other user data stored by the user; (ii) sensor data detected and/or otherwise obtained by one or more sensors; (iii) media content data including stored image data, audio data, documents, and the like; (iv) application data, which can include data collected and/or otherwise obtained and stored during use of an application; and/or any other types of data described herein.

As described herein, a power system of an electronic device is configured to convert incoming electrical power into a form that can be used to operate the device. A power system can include various components, including (i) a power source, which can be an alternating current (AC) adapter or a direct current (DC) adapter power supply; (ii) a charger input that can be configured to use a wired and/or wireless connection (which may be part of a peripheral interface, such as a USB, micro-USB interface, near-field magnetic coupling, magnetic inductive and magnetic resonance charging, and/or radio frequency (RF) charging); (iii) a power-management integrated circuit, configured to distribute power to various components of the device and ensure that the device operates within safe limits (e.g., regulating voltage, controlling current flow, and/or managing heat dissipation); and/or (iv) a battery configured to store power to provide usable power to components of one or more electronic devices.

As described herein, peripheral interfaces are electronic components (e.g., of electronic devices) that allow electronic devices to communicate with other devices or peripherals and can provide a means for input and output of data and signals. Examples of peripheral interfaces can include (i) USB and/or micro-USB interfaces configured for connecting devices to an electronic device; (ii) Bluetooth interfaces configured to allow devices to communicate with each other, including Bluetooth low energy (BLE); (iii) near-field communication (NFC) interfaces configured to be short-range wireless interfaces for operations such as access control; (iv) POGO pins, which may be small, spring-loaded pins configured to provide a charging interface; (v) wireless charging interfaces; (vi) global-position system (GPS) interfaces; (vii) Wi-Fi interfaces for providing a connection between a device and a wireless network; and (viii) sensor interfaces.

As described herein, sensors are electronic components (e.g., in and/or otherwise in electronic communication with electronic devices, such as wearable devices) configured to detect physical and environmental changes and generate electrical signals. Examples of sensors can include (i) imaging sensors for collecting imaging data (e.g., including one or more cameras disposed on a respective electronic device); (ii) biopotential-signal sensors; (iii) inertial measurement unit (e.g., IMUs) for detecting, for example, angular rate, force, magnetic field, and/or changes in acceleration; (iv) heart rate sensors for measuring a user's heart rate; (v) SpO2 sensors for measuring blood oxygen saturation and/or other biometric data of a user; (vi) capacitive sensors for detecting changes in potential at a portion of a user's body (e.g., a sensor-skin interface) and/or the proximity of other devices or objects; and (vii) light sensors (e.g., ToF sensors, infrared light sensors, or visible light sensors), and/or sensors for sensing data from the user or the user's environment. As described herein biopotential-signal-sensing components are devices used to measure electrical activity within the body (e.g., biopotential-signal sensors). Some types of biopotential-signal sensors include: (i) electroencephalography (EEG) sensors configured to measure electrical activity in the brain to diagnose neurological disorders; (ii) electrocardiography (ECG or EKG) sensors configured to measure electrical activity of the heart to diagnose heart problems; (iii) electromyography (EMG) sensors configured to measure the electrical activity of muscles and diagnose neuromuscular disorders; (iv) electrooculography (EOG) sensors configured to measure the electrical activity of eye muscles to detect eye movement and diagnose eye disorders.

As described herein, an application stored in memory of an electronic device (e.g., software) includes instructions stored in the memory. Examples of such applications include (i) games; (ii) word processors; (iii) messaging applications; (iv) media-streaming applications; (v) financial applications; (vi) calendars; (vii) clocks; (viii) web browsers; (ix) social media applications, (x) camera applications, (xi) web-based applications; (xii) health applications; (xiii) artificial-reality (AR) applications, and/or any other applications that can be stored in memory. The applications can operate in conjunction with data and/or one or more components of a device or communicatively coupled devices to perform one or more operations and/or functions.

As described herein, communication interface modules can include hardware and/or software capable of data communications using any of a variety of custom or standard wireless protocols (e.g., IEEE 802.15.4, Wi-Fi, ZigBee, 6LoWPAN, Thread, Z-Wave, Bluetooth Smart, ISA100.11a, WirelessHART, or MiWi), custom or standard wired protocols (e.g., Ethernet or HomePlug), and/or any other suitable communication protocol, including communication protocols not yet developed as of the filing date of this document. A communication interface is a mechanism that enables different systems or devices to exchange information and data with each other, including hardware, software, or a combination of both hardware and software. For example, a communication interface can refer to a physical connector and/or port on a device that enables communication with other devices (e.g., USB, Ethernet, HDMI, or Bluetooth). In some embodiments, a communication interface can refer to a software layer that enables different software programs to communicate with each other (e.g., application programming interfaces (APIs) and protocols such as HTTP and TCP/IP).

As described herein, a graphics module is a component or software module that is designed to handle graphical operations and/or processes, and can include a hardware module and/or a software module.

As described herein, non-transitory computer-readable storage media are physical devices or storage medium that can be used to store electronic data in a non-transitory form (e.g., such that the data is stored permanently until it is intentionally deleted or modified).

### Example AR Systems

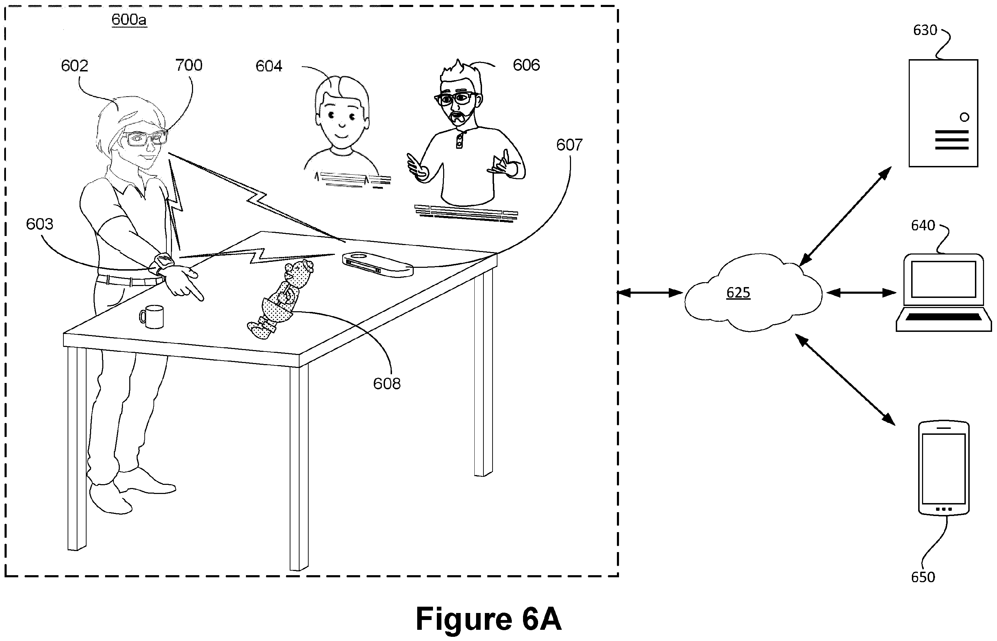

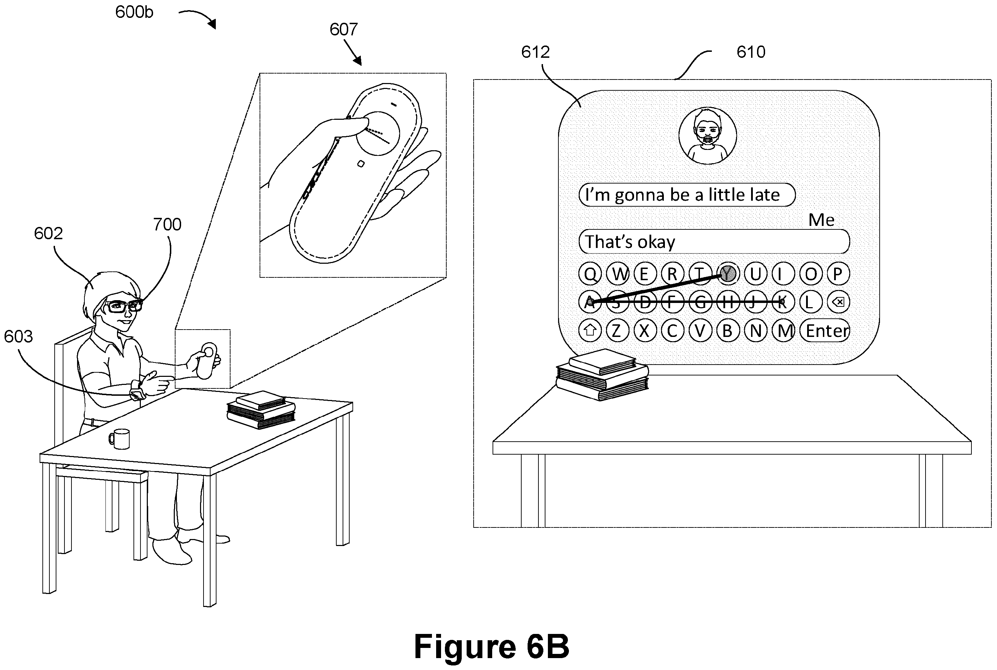

Figures 6A and 6B illustrate example AR systems, in accordance with some embodiments. Figure 6A shows a first AR system 600a and first example user interactions using a wrist-wearable device 603, a head-wearable device (e.g., AR device 700), and/or a handheld intermediary processing device (HIPD) 607. Figure 6B shows a second AR system 600b and second example user interactions using a wrist-wearable device 603, AR device 700, and/or an HIPD 607. As the skilled artisan will appreciate upon reading the descriptions provided herein, the above-example AR systems (described in detail below) can perform various functions and/or operations.

Figure 6A, a user 602 is shown wearing the wrist-wearable device 603 and the AR device 700, and having the HIPD 607 on their desk. The wrist-wearable device 603, the AR device 700, and the HIPD 607 facilitate user interaction with an AR environment. In particular, as shown by the first AR system 600a, the wrist-wearable device 603, the AR device 700, and/or the HIPD 607 cause presentation of one or more avatars 604, digital representations of contacts 606, and virtual objects 608. As discussed below, the user 602 can interact with the one or more avatars 604, digital representations of the contacts 606, and virtual objects 608 via the wrist-wearable device 603, the AR device 700, and/or the HIPD 607.

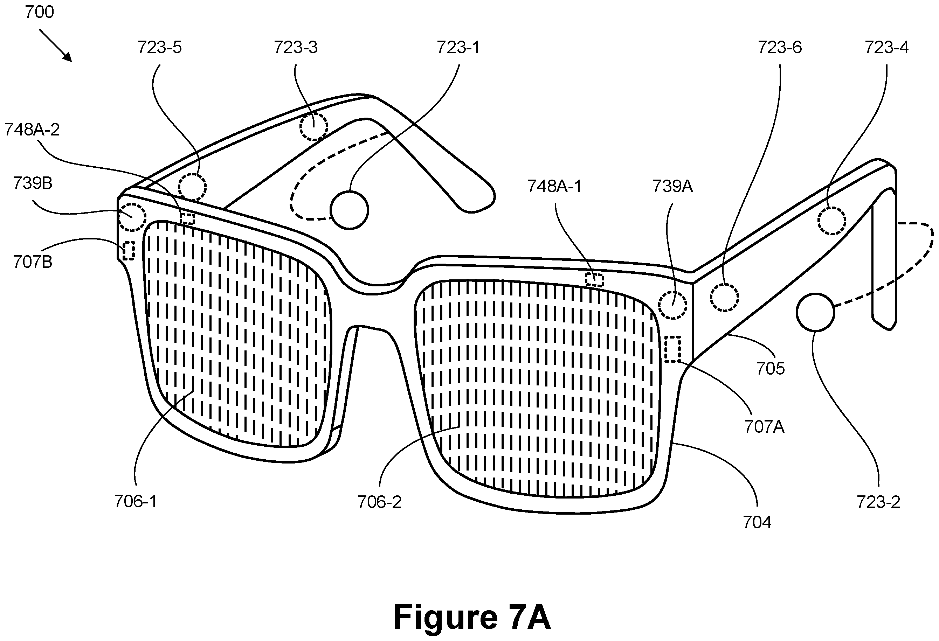

The user 602 can use any of the wrist-wearable device 603, the AR device 700, and/or the HIPD 607 to provide user inputs. For example, the user 602 can perform one or more hand gestures that are detected by the wrist-wearable device 603 (e.g., using one or more EMG sensors and/or IMUs) and/or AR device 700 (e.g., using one or more image sensors or cameras, described below in reference to Figures 7A-7B) to provide a user input. Alternatively, or additionally, the user 602 can provide a user input via one or more touch surfaces of the wrist-wearable device 603, the AR device 700, and/or the HIPD 607, and/or voice commands captured by a microphone of the wrist-wearable device 603, the AR device 700, and/or the HIPD 607. In some embodiments, the wrist-wearable device 603, the AR device 700, and/or the HIPD 607 include a digital assistant to help the user in providing a user input (e.g., completing a sequence of operations, suggesting different operations or commands, providing reminders, or confirming a command). In some embodiments, the user 602 can provide a user input via one or more facial gestures and/or facial expressions. For example, cameras of the wrist-wearable device 603, the AR device 700, and/or the HIPD 607 can track the user 602's eyes for navigating a user interface.

The wrist-wearable device 603, the AR device 700, and/or the HIPD 607 can operate alone or in conjunction to allow the user 602 to interact with the AR environment. In some embodiments, the HIPD 607 is configured to operate as a central hub or control center for the wrist-wearable device 603, the AR device 700, and/or another communicatively coupled device. For example, the user 602 can provide an input to interact with the AR environment at any of the wrist-wearable device 603, the AR device 700, and/or the HIPD 607, and the HIPD 607 can identify one or more back-end and front-end tasks to cause the performance of the requested interaction and distribute instructions to cause the performance of the one or more back-end and front-end tasks at the wrist-wearable device 603, the AR device 700, and/or the HIPD 607. In some embodiments, a back-end task is a background-processing task that is not perceptible by the user (e.g., rendering content, decompression, or compression), and a front-end task is a user-facing task that is perceptible to the user (e.g., presenting information to the user or providing feedback to the user). The HIPD 607 can perform the back-end tasks and provide the wrist-wearable device 603 and/or the AR device 700 operational data corresponding to the performed back-end tasks such that the wrist-wearable device 603 and/or the AR device 700 can perform the front-end tasks. In this way, the HIPD 607, which has more computational resources and greater thermal headroom than the wrist-wearable device 603 and/or the AR device 700, performs computationally intensive tasks and reduces the computer resource utilization and/or power usage of the wrist-wearable device 603 and/or the AR device 700.

In the example shown by the first AR system 600a, the HIPD 607 identifies one or more back-end tasks and front-end tasks associated with a user request to initiate an AR video call with one or more other users (represented by the avatar 604 and the digital representation of the contact 606) and distributes instructions to cause the performance of the one or more back-end tasks and front-end tasks. In particular, the HIPD 607 performs back-end tasks for processing and/or rendering image data (and other data) associated with the AR video call and provides operational data associated with the performed back-end tasks to the AR device 700 such that the AR device 700 performs front-end tasks for presenting the AR video call (e.g., presenting the avatar 604 and the digital representation of the contact 606).

In some embodiments, the HIPD 607 can operate as a focal or anchor point for causing the presentation of information. This allows the user 602 to be generally aware of where information is presented. For example, as shown in the first AR system 600a, the avatar 604 and the digital representation of the contact 606 are presented above the HIPD 607. In particular, the HIPD 607 and the AR device 700 operate in conjunction to determine a location for presenting the avatar 604 and the digital representation of the contact 606. In some embodiments, information can be presented within a predetermined distance from the HIPD 607 (e.g., within five meters). For example, as shown in the first AR system 600a, virtual object 608 is presented on the desk some distance from the HIPD 607. Similar to the above example, the HIPD 607 and the AR device 700 can operate in conjunction to determine a location for presenting the virtual object 608. Alternatively, in some embodiments, presentation of information is not bound by the HIPD 607. More specifically, the avatar 604, the digital representation of the contact 606, and the virtual object 608 do not have to be presented within a predetermined distance of the HIPD 607.

User inputs provided at the wrist-wearable device 603, the AR device 700, and/or the HIPD 607 are coordinated such that the user can use any device to initiate, continue, and/or complete an operation. For example, the user 602 can provide a user input to the AR device 700 to cause the AR device 700 to present the virtual object 608 and, while the virtual object 608 is presented by the AR device 700, the user 602 can provide one or more hand gestures via the wrist-wearable device 603 to interact and/or manipulate the virtual object 608.

Figure 6B shows the user 602 wearing the wrist-wearable device 603 and the AR device 700, and holding the HIPD 607. In the second AR system 600b, the wrist-wearable device 603, the AR device 700, and/or the HIPD 607 are used to receive and/or provide one or more messages to a contact of the user 602. In particular, the wrist-wearable device 603, the AR device 700, and/or the HIPD 607 detect and coordinate one or more user inputs to initiate a messaging application and prepare a response to a received message via the messaging application.

In some embodiments, the user 602 initiates, via a user input, an application on the wrist-wearable device 603, the AR device 700, and/or the HIPD 607 that causes the application to initiate on at least one device. For example, in the second AR system 600b, the user 602 performs a hand gesture associated with a command for initiating a messaging application (represented by messaging user interface 612), the wrist-wearable device 603 detects the hand gesture, and, based on a determination that the user 602 is wearing AR device 700, causes the AR device 700 to present a messaging user interface 612 of the messaging application. The AR device 700 can present the messaging user interface 612 to the user 602 via its display (e.g., as shown by user 602's field of view 610). In some embodiments, the application is initiated and can be run on the device (e.g., the wrist-wearable device 603, the AR device 700, and/or the HIPD 607) that detects the user input to initiate the application, and the device provides another device operational data to cause the presentation of the messaging application. For example, the wrist-wearable device 603 can detect the user input to initiate a messaging application, initiate and run the messaging application, and provide operational data to the AR device 700 and/or the HIPD 607 to cause presentation of the messaging application. Alternatively, the application can be initiated and run at a device other than the device that detected the user input. For example, the wrist-wearable device 603 can detect the hand gesture associated with initiating the messaging application and cause the HIPD 607 to run the messaging application and coordinate the presentation of the messaging application.

Further, the user 602 can provide a user input provided at the wrist-wearable device 603, the AR device 700, and/or the HIPD 607 to continue and/or complete an operation initiated at another device. For example, after initiating the messaging application via the wrist-wearable device 603 and while the AR device 700 presents the messaging user interface 612, the user 602 can provide an input at the HIPD 607 to prepare a response (e.g., shown by the swipe gesture performed on the HIPD 607). The user 602's gestures performed on the HIPD 607 can be provided and/or displayed on another device. For example, the user 602's swipe gestures performed on the HIPD 607 are displayed on a virtual keyboard of the messaging user interface 612 displayed by the AR device 700.

In some embodiments, the wrist-wearable device 603, the AR device 700, the HIPD 607, and/or other communicatively coupled devices can present one or more notifications to the user 602. The notification can be an indication of a new message, an incoming call, an application update, a status update, etc. The user 602 can select the notification via the wrist-wearable device 603, the AR device 700, or the HIPD 607 and cause presentation of an application or operation associated with the notification on at least one device. For example, the user 602 can receive a notification that a message was received at the wrist-wearable device 603, the AR device 700, the HIPD 607, and/or other communicatively coupled device and provide a user input at the wrist-wearable device 603, the AR device 700, and/or the HIPD 607 to review the notification, and the device detecting the user input can cause an application associated with the notification to be initiated and/or presented at the wrist-wearable device 603, the AR device 700, and/or the HIPD 607.

While the above example describes coordinated inputs used to interact with a messaging application, the skilled artisan will appreciate upon reading the descriptions that user inputs can be coordinated to interact with any number of applications including, but not limited to, gaming applications, social media applications, camera applications, web-based applications, financial applications, etc. For example, the AR device 700 can present to the user 602 game application data and the HIPD 607 can use a controller to provide inputs to the game. Similarly, the user 602 can use the wrist-wearable device 603 to initiate a camera of the AR device 700, and the user can use the wrist-wearable device 603, the AR device 700, and/or the HIPD 607 to manipulate the image capture (e.g., zoom in or out or apply filters) and capture image data.

Having discussed example AR systems, devices for interacting with such AR systems, and other computing systems more generally, devices and components will now be discussed in greater detail below. Some definitions of devices and components that can be included in some or all of the example devices discussed below are defined here for ease of reference. A skilled artisan will appreciate that certain types of the components described below may be more suitable for a particular set of devices and less suitable for a different set of devices. But subsequent references to the components defined here should be considered to be encompassed by the definitions provided.

In some embodiments discussed below, example devices and systems, including electronic devices and systems, will be discussed. Such example devices and systems are not intended to be limiting, and one of skill in the art will understand that alternative devices and systems to the example devices and systems described herein may be used to perform the operations and construct the systems and devices that are described herein.

As described herein, an electronic device is a device that uses electrical energy to perform a specific function. It can be any physical object that contains electronic components such as transistors, resistors, capacitors, diodes, and integrated circuits. Examples of electronic devices include smartphones, laptops, digital cameras, televisions, gaming consoles, and music players, as well as the example electronic devices discussed herein. As described herein, an intermediary electronic device is a device that sits between two other electronic devices and/or a subset of components of one or more electronic devices, which facilitates communication, and/or data processing, and/or data transfer between the respective electronic devices and/or electronic components.

### Example Head-Wearable Devices

Figures 7A, 7B-1, 7B-2, and 7C show example head-wearable devices, in accordance with some embodiments. Head-wearable devices can include, but are not limited to, AR devices 700 (e.g., AR or smart eyewear devices, such as smart glasses, smart monocles, smart contacts, etc.), VR devices 710 (e.g., VR headsets or head-mounted displays (HMDs)), or other ocularly coupled devices. The AR devices 700 and the VR devices 710 are instances of the smart glasses 102 described in reference to Figures 1-5 herein, such that the head-wearable device should be understood to have the features of the AR devices 700 and/or the VR devices 710 and vice versa. The AR devices 700 and the VR devices 710 can perform various functions and/or operations associated with navigating through user interfaces and selectively opening applications, as well as the functions and/or operations.

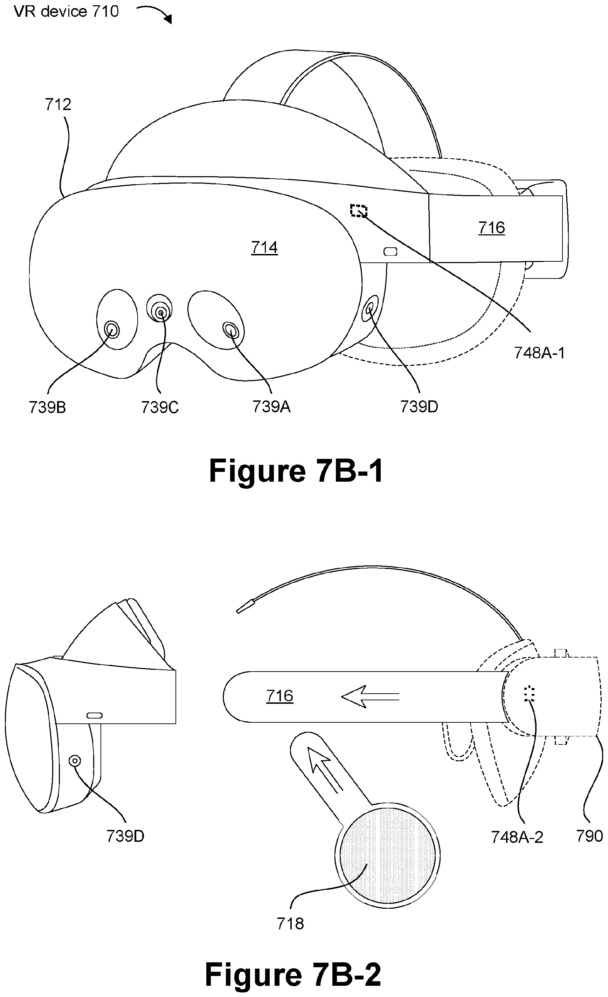

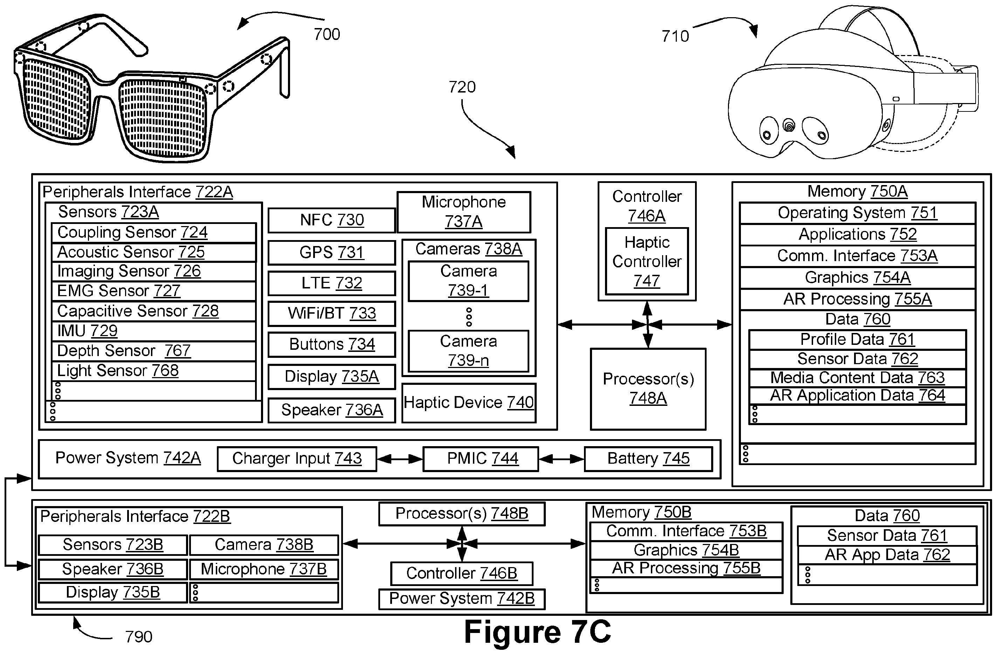

In some embodiments, an AR system (e.g., Figures 6A-6B; AR systems 600a-600d) includes an AR device 700 (as shown in Figure 7A) and/or VR device 710 (as shown in Figures 7B-1-B-2). In some embodiments, the AR device 700 and the VR device 710 can include one or more analogous components (e.g., components for presenting interactive AR environments, such as processors, memory, and/or presentation devices, including one or more displays and/or one or more waveguides), some of which are described in more detail with respect to Figure 7C. The head-wearable devices can use display projectors (e.g., display projector assemblies 707A and 707B) and/or waveguides for projecting representations of data to a user. Some embodiments of head-wearable devices do not include displays.

Figure 7A shows an example visual depiction of the AR device 700 (e.g., which may also be described herein as augmented-reality glasses and/or smart glasses). The AR device 700 can work in conjunction with additional electronic components that are not shown in Figures 7A, such as a wearable accessory device and/or an intermediary processing device, in electronic communication or otherwise configured to be used in conjunction with the AR device 700. In some embodiments, the wearable accessory device and/or the intermediary processing device may be configured to couple with the AR device 700 via a coupling mechanism in electronic communication with a coupling sensor 724, where the coupling sensor 724 can detect when an electronic device becomes physically or electronically coupled with the AR device 700. In some embodiments, the AR device 700 can be configured to couple to a housing (e.g., a portion of frame 704 or temple arms 705), which may include one or more additional coupling mechanisms configured to couple with additional accessory devices. The components shown in Figure 7A can be implemented in hardware, software, firmware, or a combination thereof, including one or more signal-processing components and/or application-specific integrated circuits (ASICs).

The AR device 700 includes mechanical glasses components, including a frame 704 configured to hold one or more lenses (e.g., one or both lenses 706-1 and 706-2). One of ordinary skill in the art will appreciate that the AR device 700 can include additional mechanical components, such as hinges configured to allow portions of the frame 704 of the AR device 700 to be folded and unfolded, a bridge configured to span the gap between the lenses 706-1 and 706-2 and rest on the user's nose, nose pads configured to rest on the bridge of the nose and provide support for the AR device 700, earpieces configured to rest on the user's ears and provide additional support for the AR device 700, temple arms 705 configured to extend from the hinges to the earpieces of the AR device 700, and the like. One of ordinary skill in the art will further appreciate that some examples of the AR device 700 can include none of the mechanical components described herein. For example, smart contact lenses configured to present AR to users may not include any components of the AR device 700.

The lenses 706-1 and 706-2 can be individual displays or display devices (e.g., a waveguide for projected representations). The lenses 706-1 and 706-2 may act together or independently to present an image or series of images to a user. In some embodiments, the lenses 706-1 and 706-2 can operate in conjunction with one or more display projector assemblies 707A and 707B to present image data to a user. While the AR device 700 includes two displays, embodiments of this disclosure may be implemented in AR devices with a single near-eye display (NED) or more than two NEDs.

The AR device 700 includes electronic components, many of which will be described in more detail below with respect to Figure 7C. Some example electronic components are illustrated in Figure 7A, including sensors 723-1, 723-2, 723-3, 723-4, 723-5, and 723-6, which can be distributed along a substantial portion of the frame 704 of the AR device 700. The different types of sensors are described below in reference to Figure 7C. The AR device 700 also includes a left camera 739A and a right camera 739B, which are located on different sides of the frame 704. And the eyewear device includes one or more processors 748A and 748B (e.g., an integral microprocessor, such as an ASIC) that is embedded into a portion of the frame 704.

Figures 7B-1 and 7B-2 show an example visual depiction of the VR device 710 (e.g., a head-mounted display (HMD) 712, also referred to herein as an AR headset, a head-wearable device, or a VR headset). The HMD 712 includes a front body 714 and a frame 716 (e.g., a strap or band) shaped to fit around a user's head. In some embodiments, the front body 714 and/or the frame 716 includes one or more electronic elements for facilitating presentation of and/or interactions with an AR and/or VR system (e.g., displays, processors (e.g., processor 748A-1), IMUs, tracking emitters or detectors, or sensors). In some embodiments, the HMD 712 includes output audio transducers (e.g., an audio transducer 718-1), as shown in Figure 7B-2. In some embodiments, one or more components, such as the output audio transducer(s) 718 and the frame 716, can be configured to attach and detach (e.g., are detachably attachable) to the HMD 712 (e.g., a portion or all of the frame 716 and/or the output audio transducer(s) 718), as shown in Figure 7B-2. In some embodiments, coupling a detachable component to the HMD 712 causes the detachable component to come into electronic communication with the HMD 712. The VR device 710 includes electronic components, many of which will be described in more detail below with respect to Figure 7C.

Figures 7B-1 and 7B-2 also show that the VR device 710 having one or more cameras, such as the left camera 739A and the right camera 739B, which can be analogous to the left and right cameras on the frame 704 of the AR device 700. In some embodiments, the VR device 710 includes one or more additional cameras (e.g., cameras 739C and 739D), which can be configured to augment image data obtained by the cameras 739A and 739B by providing more information. For example, the camera 739C can be used to supply color information that is not discerned by cameras 739A and 739B. In some embodiments, one or more of the cameras 739A to 739D can include an optional IR (infrared) cut filter configured to remove IR light from being received at the respective camera sensors.

The VR device 710 can include a housing 790 storing one or more components of the VR device 710 and/or additional components of the VR device 710. The housing 790 can be a modular electronic device configured to couple with the VR device 710 (or an AR device 700) and supplement and/or extend the capabilities of the VR device 710 (or an AR device 700). For example, the housing 790 can include additional sensors, cameras, power sources, and processors (e.g., processor 748A-2). to improve and/or increase the functionality of the VR device 710. Examples of the different components included in the housing 790 are described below in reference to Figure 7C.

Alternatively, or in addition, in some embodiments, the head-wearable device, such as the VR device 710 and/or the AR device 700, includes, or is communicatively coupled to, another external device (e.g., a paired device), such as an HIPD 607 and/or an optional neckband. The optional neckband can couple to the head-wearable device via one or more connectors (e.g., wired or wireless connectors). The head-wearable device and the neckband can operate independently without any wired or wireless connection between them. In some embodiments, the components of the head-wearable device and the neckband are located on one or more additional peripheral devices paired with the head-wearable device, the neckband, or some combination thereof. Furthermore, the neckband is intended to represent any suitable type or form of paired device. Thus, the following discussion of neckbands may also apply to various other paired devices, such as smartwatches, smartphones, wrist bands, other wearable devices, hand-held controllers, tablet computers, or laptop computers.

In some situations, pairing external devices, such as an intermediary processing device (e.g., an HIPD device 607, an optional neckband, and/or a wearable accessory device) with the head-wearable devices (e.g., an AR device 700 and/or a VR device 710) enables the head-wearable devices to achieve a similar form factor of a pair of glasses while still providing sufficient battery and computational power for expanded capabilities. Some, or all, of the battery power, computational resources, and/or additional features of the head-wearable devices can be provided by a paired device or shared between a paired device and the head-wearable devices, thus reducing the weight, heat profile, and form factor of the head-wearable device overall while allowing the head-wearable device to retain its desired functionality. For example, the intermediary processing device (e.g., the HIPD 607) can allow components that would otherwise be included in a head-wearable device to be included in the intermediary processing device (and/or a wearable device or accessory device), thereby shifting a weight load from the user's head and neck to one or more other portions of the user's body. In some embodiments, the intermediary processing device has a larger surface area over which to diffuse and disperse heat to the ambient environment. Thus, the intermediary processing device can allow for greater battery and computational capacity than might otherwise have been possible on the head-wearable devices, standing alone. Because weight carried in the intermediary processing device can be less invasive to a user than weight carried in the head-wearable devices, a user may tolerate wearing a lighter eyewear device and carrying or wearing the paired device for greater lengths of time than the user would tolerate wearing a heavier eyewear device standing alone, thereby enabling an AR environment to be incorporated more fully into a user's day-to-day activities.

In some embodiments, the intermediary processing device is communicatively coupled with the head-wearable device and/or to other devices. The other devices may provide certain functions (e.g., tracking, localizing, depth mapping, processing, and/or storage) to the head-wearable device. In some embodiments, the intermediary processing device includes a controller and a power source. In some embodiments, sensors of the intermediary processing device are configured to sense additional data that can be shared with the head-wearable devices in an electronic format (analog or digital).

The controller of the intermediary processing device processes information generated by the sensors on the intermediary processing device and/or the head-wearable devices. The intermediary processing device, such as an HIPD 607, can process information generated by one or more of its sensors and/or information provided by other communicatively coupled devices. For example, a head-wearable device can include an IMU, and the intermediary processing device (a neckband and/or an HIPD 607) can compute all inertial and spatial calculations from the IMUs located on the head-wearable device. Additional examples of processing performed by a communicatively coupled device, such as the HIPD 607.

AR systems may include a variety of types of visual feedback mechanisms. For example, display devices in the AR devices 700 and/or the VR devices 710 may include one or more liquid-crystal displays (LCDs), light emitting diode (LED) displays, organic LED (OLED) displays, and/or any other suitable type of display screen. AR systems may include a single display screen for both eyes or may provide a display screen for each eye, which may allow for additional flexibility for varifocal adjustments or for correcting a refractive error associated with the user's vision. Some AR systems also include optical subsystems having one or more lenses (e.g., conventional concave or convex lenses, Fresnel lenses, or adjustable liquid lenses) through which a user may view a display screen. In addition to or instead of using display screens, some AR systems include one or more projection systems. For example, display devices in the AR device 700 and/or the VR device 710 may include micro-LED projectors that project light (e.g., using a waveguide) into display devices, such as clear combiner lenses that allow ambient light to pass through. The display devices may refract the projected light toward a user's pupil and may enable a user to simultaneously view both AR content and the real world. AR systems may also be configured with any other suitable type or form of image projection system. As noted, some AR systems may, instead of blending an artificial reality with actual reality, substantially replace one or more of a user's sensory perceptions of the real world with a virtual experience.

While the example head-wearable devices are respectively described herein as the AR device 700 and the VR device 710, either or both of the example head-wearable devices described herein can be configured to present fully immersive VR scenes presented in substantially all of a user's field of view, additionally or alternatively to, subtler augmented-reality scenes that are presented within a portion, less than all, of the user's field of view.

In some embodiments, the AR device 700 and/or the VR device 710 can include haptic feedback systems. The haptic feedback systems may provide various types of cutaneous feedback, including vibration, force, traction, shear, texture, and/or temperature. The haptic feedback systems may also provide various types of kinesthetic feedback, such as motion and compliance. The haptic feedback can be implemented using motors, piezoelectric actuators, fluidic systems, and/or a variety of other types of feedback mechanisms. The haptic feedback systems may be implemented independently of other AR devices, within other AR devices, and/or in conjunction with other AR devices (e.g., wrist-wearable devices that may be incorporated into headwear, gloves, body suits, handheld controllers, environmental devices (e.g., chairs or floormats), and/or any other type of device or system, such as a wrist-wearable device 603, an HIPD 607, smart textile-based garment), and/or other devices described herein.

Figure 7C illustrates a computing system 720 and an optional housing 790, each of which shows components that can be included in a head-wearable device (e.g., the AR device 700 and/or the VR device 710). In some embodiments, more or fewer components can be included in the optional housing 790 depending on practical restraints of the respective head-wearable device being described. Additionally or alternatively, the optional housing 790 can include additional components to expand and/or augment the functionality of a head-wearable device.

In some embodiments, the computing system 720 and/or the optional housing 790 can include one or more peripheral interfaces 722A and 722B, one or more power systems 742A and 742B (including charger input 743, PMIC 744, and battery 745), one or more controllers 746A and 746B (including one or more haptic controllers 747), one or more processors 748A and 748B (as defined above, including any of the examples provided), and memory 750A and 750B, which can all be in electronic communication with each other. For example, the one or more processors 748A and/or 748B can be configured to execute instructions stored in the memory 750A and/or 750B, which can cause a controller of the one or more controllers 746A and/or 746B to cause operations to be performed at one or more peripheral devices of the peripherals interfaces 722A and/or 722B. In some embodiments, each operation described can occur based on electrical power provided by the power system 742A and/or 742B.

In some embodiments, the peripherals interface 722A can include one or more devices configured to be part of the computing system 720, many of which have been defined above. For example, the peripherals interface can include one or more sensors 723A. Some example sensors include one or more coupling sensors 724, one or more acoustic sensors 725, one or more imaging sensors 726, one or more EMG sensors 727, one or more capacitive sensors 728, and/or one or more IMUs 729. In some embodiments, the sensors 723A further include depth sensors 767, light sensors 768, and/or any other types of sensors defined above or described with respect to any other embodiments discussed herein.

In some embodiments, the peripherals interface can include one or more additional peripheral devices, including one or more NFC devices 730, one or more GPS devices 731, one or more LTE devices 732, one or more Wi-Fi and/or Bluetooth devices 733, one or more buttons 734 (e.g., including buttons that are slidable or otherwise adjustable), one or more displays 735A, one or more speakers 736A, one or more microphones 737A, one or more cameras 738A (e.g., including the first camera 739-1 through nth camera 739-n, which are analogous to the left camera 739A and/or the right camera 739B), one or more haptic devices 740, and/or any other types of peripheral devices defined above or described with respect to any other embodiments discussed herein.

The head-wearable devices can include a variety of types of visual feedback mechanisms (e.g., presentation devices). For example, display devices in the AR device 700 and/or the VR device 710 can include one or more liquid-crystal displays (LCDs), light emitting diode (LED) displays, organic LED (OLED) displays, micro-LEDs, and/or any other suitable types of display screens. The head-wearable devices can include a single display screen (e.g., configured to be seen by both eyes) and/or can provide separate display screens for each eye, which can allow for additional flexibility for varifocal adjustments and/or for correcting a refractive error associated with the user's vision. Some embodiments of the head-wearable devices also include optical subsystems having one or more lenses (e.g., conventional concave or convex lenses, Fresnel lenses, or adjustable liquid lenses) through which a user can view a display screen. For example, respective displays 735A can be coupled to each of the lenses 706-1 and 706-2 of the AR device 700. The displays 735A coupled to each of the lenses 706-1 and 706-2 can act together or independently to present an image or series of images to a user. In some embodiments, the AR device 700 and/or the VR device 710 includes a single display 735A (e.g., a near-eye display) or more than two displays 735A.

In some embodiments, a first set of one or more displays 735A can be used to present an augmented-reality environment, and a second set of one or more display devices 735A can be used to present a VR environment. In some embodiments, one or more waveguides are used in conjunction with presenting AR content to the user of the AR device 700 and/or the VR device 710 (e.g., as a means of delivering light from a display projector assembly and/or one or more displays 735A to the user's eyes). In some embodiments, one or more waveguides are fully or partially integrated into the AR device 700 and/or the VR device 710. Additionally, or alternatively, to display screens, some AR systems include one or more projection systems. For example, display devices in the AR device 700 and/or the VR device 710 can include micro-LED projectors that project light (e.g., using a waveguide) into display devices, such as clear combiner lenses that allow ambient light to pass through. The display devices can refract the projected light toward a user's pupil and can enable a user to simultaneously view both AR content and the real world. The head-wearable devices can also be configured with any other suitable type or form of image projection system. In some embodiments, one or more waveguides are provided, additionally or alternatively, to the one or more display(s) 735A.

In some embodiments of the head-wearable devices, ambient light and/or a real-world live view (e.g., a live feed of the surrounding environment that a user would normally see) can be passed through a display element of a respective head-wearable device presenting aspects of the AR system. In some embodiments, ambient light and/or the real-world live view can be passed through a portion, less than all, of an AR environment presented within a user's field of view (e.g., a portion of the AR environment co-located with a physical object in the user's real-world environment that is within a designated boundary (e.g., a guardian boundary) configured to be used by the user while they are interacting with the AR environment). For example, a visual user interface element (e.g., a notification user interface element) can be presented at the head-wearable devices, and an amount of ambient light and/or the real-world live view (e.g., 15%-50% of the ambient light and/or the real-world live view) can be passed through the user interface element, such that the user can distinguish at least a portion of the physical environment over which the user interface element is being displayed.

The head-wearable devices can include one or more external displays 735A for presenting information to users. For example, an external display 735A can be used to show a current battery level, network activity (e.g., connected, disconnected), current activity (e.g., playing a game, in a call, in a meeting, or watching a movie), and/or other relevant information. In some embodiments, the external displays 735A can be used to communicate with others. For example, a user of the head-wearable device can cause the external displays 735A to present a "do not disturb" notification. The external displays 735A can also be used by the user to share any information captured by the one or more components of the peripherals interface 722A and/or generated by the head-wearable device (e.g., during operation and/or performance of one or more applications).

The memory 750A can include instructions and/or data executable by one or more processors 748A (and/or processors 748B of the housing 790) and/or a memory controller of the one or more controllers 746A (and/or controller 746B of the housing 790). The memory 750A can include one or more operating systems 751, one or more applications 752, one or more communication interface modules 753A, one or more graphics modules 754A, one or more AR processing modules 755A, and/or any other types of modules or components defined above or described with respect to any other embodiments discussed herein.

The data 760 stored in memory 750A can be used in conjunction with one or more of the applications and/or programs discussed above. The data 760 can include profile data 761, sensor data 762, media content data 763, AR application data 764; and/or any other types of data defined above or described with respect to any other embodiments discussed herein.

In some embodiments, the controller 746A of the head-wearable devices processes information generated by the sensors 723A on the head-wearable devices and/or another component of the head-wearable devices and/or communicatively coupled with the head-wearable devices (e.g., components of the housing 790, such as components of peripherals interface 722B). For example, the controller 746A can process information from the acoustic sensors 725 and/or image sensors 726. For each detected sound, the controller 746A can perform a direction of arrival (DOA) estimation to estimate a direction from which the detected sound arrived at a head-wearable device. As one or more of the acoustic sensors 725 detect sounds, the controller 746A can populate an audio data set with the information (e.g., represented by sensor data 762).

In some embodiments, a physical electronic connector can convey information between the head-wearable devices and another electronic device, and/or between one or more processors 748A of the head-wearable devices and the controller 746A. The information can be in the form of optical data, electrical data, wireless data, or any other transmittable data form. Moving the processing of information generated by the head-wearable devices to an intermediary processing device can reduce weight and heat in the eyewear device, making it more comfortable and safer for a user. In some embodiments, an optional accessory device (e.g., an electronic neckband or an HIPD 607) is coupled to the head-wearable devices via one or more connectors. The connectors can be wired or wireless connectors and can include electrical and/or non-electrical (e.g., structural) components. In some embodiments, the head-wearable devices and the accessory device can operate independently without any wired or wireless connection between them.

The head-wearable devices can include various types of computer vision components and subsystems. For example, the AR device 700 and/or the VR device 710 can include one or more optical sensors such as two-dimensional (2D) or three-dimensional (3D) cameras, ToF depth sensors, single-beam or sweeping laser rangefinders, 3D LiDAR sensors, and/or any other suitable type or form of optical sensor. A head-wearable device can process data from one or more of these sensors to identify a location of a user and/or aspects of the user's real-world physical surroundings, including the locations of real-world objects within the real-world physical surroundings. In some embodiments, the methods described herein are used to map the real world, to provide a user with context about real-world surroundings, and/or to generate interactable virtual objects (which can be replicas or digital twins of real-world objects that can be interacted with an AR environment), among a variety of other functions. For example, Figures 7B-1 and 7B-2 show the VR device 710 having cameras 739A-739D, which can be used to provide depth information for creating a voxel field and a 2D mesh to provide object information to the user to avoid collisions.

The optional housing 790 can include analogous components to those describe above with respect to the computing system 720. For example, the optional housing 790 can include a respective peripherals interface 722B, including more or fewer components to those described above with respect to the peripherals interface 722A. As described above, the components of the optional housing 790 can be used to augment and/or expand on the functionality of the head-wearable devices. For example, the optional housing 790 can include respective sensors 723B, speakers 736B, displays 735B, microphones 737B, cameras 738B, and/or other components to capture and/or present data. Similarly, the optional housing 790 can include one or more processors 748B, controllers 746B, and/or memory 750B (including respective communication interface modules 753B, one or more graphics modules 754B, one or more AR processing modules 755B) that can be used individually and/or in conjunction with the components of the computing system 720.

The techniques described above in Figures 7A-7C can be used with different head-wearable devices. In some embodiments, the head-wearable devices (e.g., the AR device 700 and/or the VR device 710) can be used in conjunction with one or more wearable devices such as a wrist-wearable device 603 (or components thereof), as well as an HIPD 607.

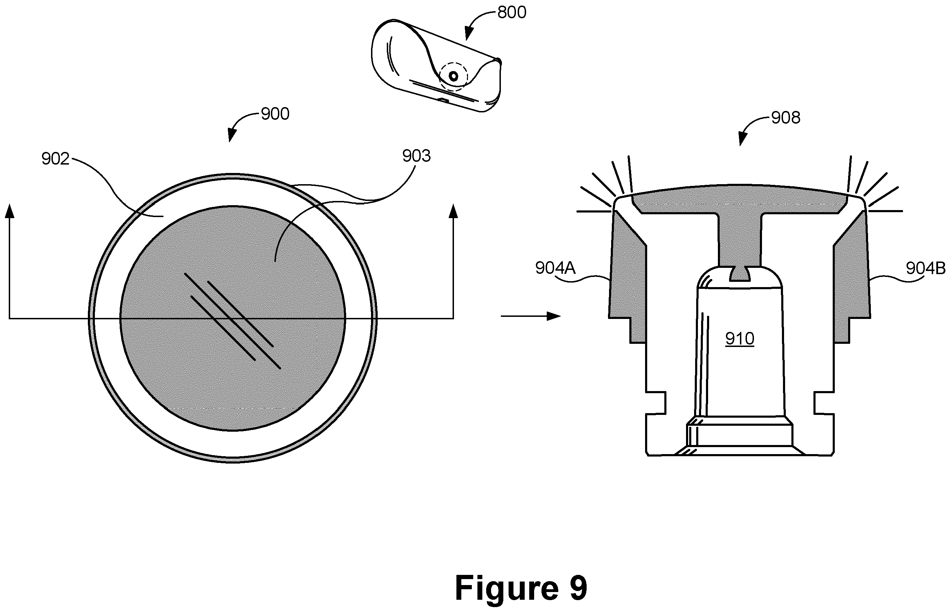

Figures 8A-8B illustrates a portable charging case 800 that includes an LED ring 802 that is integrated with a clasp 804 of the portable charging case 800, in accordance with some embodiments. Figure 8A illustrates the portable charging case 800 in a closed positions 806 where the LED ring 802 is visible to indicate a charging status of either the portable charging case 800 and/or a pair of smart glasses (not pictured) housed within the portable charging case 800. In some embodiments, the clasp 804 is either configured to either be wholly or partially capable of keeping the lid portion 808 shut. In some embodiments, one or more magnets can be configured to either be wholly or partially capable of keeping the lip portion shut. Figure 8A also shows that the LED ring 802 does not light up the center portion 810, which is further detailed in reference to Figure 9. In some embodiments, the clasp is also magnetic and couples with the LED ring 802. In some embodiments, the clasp is a button and clips into place.

Figure 8B illustrates the portable charging case 800 being in a closed position 812 in which the LED ring 802 is still visible to the user and still provides the same functionality as described in reference to Figure 8A. As shown in Figure 8B additional magnets 814A and 814B can be placed on the portable charging case 800 to additionally secure the charging case while in the closed position. In some embodiments, the locations of the additional magnets 814A and 814B can vary, along with the number of magnets. For example, in some embodiments, the magnet(s) 816 circumvent the LED ring 802, and in some instances the magnet(s) 816 are multiple magnets with different polarities to adjust the force required to undo the clasp. In that example, the clasp 804 can be made of a ferrous material configured to attach to the magnets(s) 816.

Figure 9 illustrates a cutaway view of the LED ring shown in Figures 8A and 8B, in accordance with some embodiments. As shown in the first pane 900 the clasp portion that includes the LED ring is shown. As will become clear, only the ring portion 902 emits light while the center portion and side portions do not emit light, thereby providing a light ring to the user. In some embodiments, the charging case 800 is configured to come in different colors while still maintaining the same light ring without light bleed into the surrounding areas 903. In some embodiments, light bleed is reduced by adding titanium dioxide to the surrounding areas to increase opacity. This addition of titanium dioxide is useful for surrounding areas that have a lighter color (e.g., brown plastic). In some embodiments, the material of the surrounding areas are constructed with polycarbonate and ABS and at least titanium dioxide between 0.1-5% of the total mass of the material. In some embodiments, excessive titanium dioxide could result in cosmetic issues of the surface, thus, adding beyond 5% of titanium dioxide to the material is not preferred. I

Figure 9 shows in a second pane a cutaway view 908 of the LED ring that includes the LED ring, and also illustrates the different materials such that an LED ring is shown to the user. For example, the cutaway shows three regions (e.g., continuous side regions 904A and 904B, and center portion 906 (which correspond to the surrounding area 903) in which light from the LED is blocked to produce the ring portion 902) that include the titanium dioxide material to reduce light bleeding. While titanium dioxide is needed for lighter colors, it is not always necessary for darker colors such as black. The cutaway view 908 also shows the location 910 in which one or more LED(s) will sit. Figure 9 also shows that a first shot of material is provided to the surrounding areas 903 and then a second shot of material is provided to produce ring portion 902 which includes a location 910 for an LED, thereby producing a light pipe.

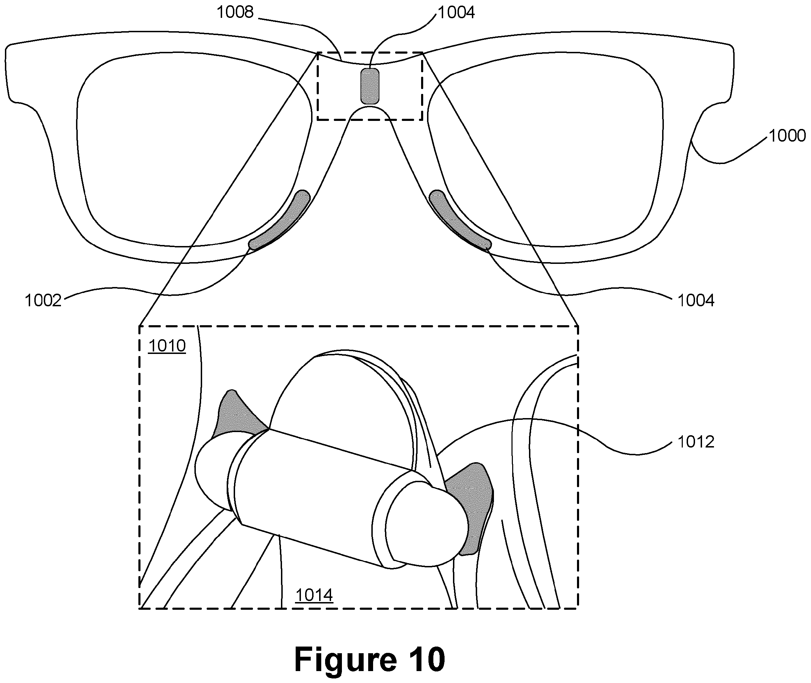

Figure 10 illustrates fixed locations on a pair of smart glasses, such that smart glasses of other designs while maintaining these points can interface with the portable charging case, in accordance with some embodiments. As is shown in Figure 10, in one example certain portions of a pair of smart glasses remain fixed, but allow for variations in shape and size in non-fixed locations, thereby making a modular smart glasses platform that allows for creating multiple smart glasses with different shapes that can all interface with a single portable charging case. Having a modular platform reduces the number of stock keeping units (SKUs) required for a product by allowing for commonality between certain components, e.g., having the same portable smart charging case.

Figure 10 illustrates example locations in which a pair of smart glasses 1000 have fixed regions 1002, 1004, and 1006 that allow for the pair of smart glasses to interface (e.g., couple and receive a charge) with the portable charging case. These fixed regions, in some embodiments are located around the nose bridge 1008 of a pair of smart glasses 1000, as in this example, this is where the portable smart glasses are configured to receive a charge and be secured within the portable charging case. This is illustrated in a zoomed in region 1010 which shows how the pair of smart glasses 1000 is coupled to a location 1012 within the portable charging case 1014. In some embodiments, the locations can be different depending on the location in which the pair of smart glasses 1000 receive a charge and/or how the pair of smart glasses are configured to be secured within the portable charging case 1014. In some embodiments, the overall width and or depth of the pair of smart glasses can also be constrained across all variations such that they are all configured to fit within a single type of portable charging case. In some embodiments, the fixed regions 1002, 1004, and 1006 can have tolerances that allow for certain amount of variation in design with minimal changes to removal and insertion force (e.g., less than 6 Newtons of removal and insertion force) such that different SKUs can be fit within the portable charging case.

Figure 10 also shows that, in some embodiments, that fixed regions 1016A and 1016B can be placed right above the nose pads on a pair of smart glasses. In some embodiments, these positions vary based on the design and physical constraints of the retention bracket located withing the portable charging case.

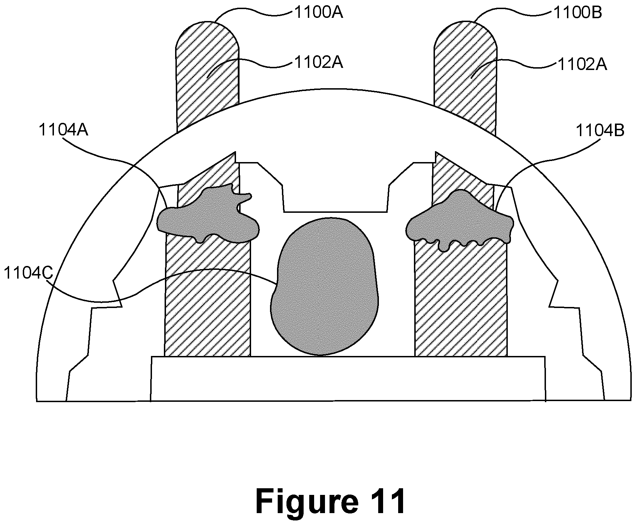

Figure 11 illustrates an example nose bridge that includes two pogo pins for transferring a charge to a pair of smart glasses, where the nose bridge includes techniques for minimizing issues related to corrosion, in accordance with some embodiments. Smart glasses worn by users have the potential of being placed within a portable charging case with moisture on them, usually from sweat of the wearer. Sweat, which is corrosive, can reduce the performance of the pogo pins (e.g., by not allowing them to make sufficient contact due to corrosion reducing mobility and/or reducing charging effectiveness due to surface corrosion at the contact points).

Figure 11 in particular shows that the pogo pins having a plurality of corrosion mitigation techniques. The pogo pins 1100A and 1100B are coated with a hydrophobic coating 1102A and 1102B. In some embodiments, the solder pads, which can be susceptible to corrosion, are covered in tape. In some embodiments, the pogo pins are coated in grease 1104A 1104B and 1104C (an additional grease path) to create a barrier between the pogo pins to prevent liquid bridging and electrolysis.

(D1) In accordance with some embodiments a portable charging case for smart glasses comprises a cavity configured to house a pair of smart glasses. The portable charging case also comprises a lid configured to enclose the cavity, and a clasp that attaches the lid to another portion of the portable charging case. The portable charging case also comprises a light integrated into a portion of the clasp that is attached the other portion of the portable charging case, and the light ring is configured to provide (i) a charging status information of the portable charging case, and (ii) a charging status information for a pair of smart glasses inserted into the cavity. Charging status information can indicate whether the case is charged, case is charging, glasses are charged, glasses are charging, or a combination of charging statuses. For example, Figures 8A-9 illustrate a portable charging case that includes a clasp with an integrated light that indicates charging statuses of portable charging case and the a pair of smart glasses enclosed within the charging case.

(D2) In some embodiments of D1, the portable charging case of claim 1, the cavity includes a pogo pin configured to supply a charge to a pair of smart glasses. Multiple pogo pins can be used based on the charging implementation and information that is passed through the charging case and glasses. For example, Figure 11 illustrates that pogo pins 1100A and 1100B.

(D3) In some embodiments of D2, the pogo pin includes a coating that resists corrosion of the pogo pin from moisture. For example, coatings such as a hydrophobic coating that still allows for transmission of electricity. For example, Figure 11 illustrates that pogo pins 1100A and 1100B are coated with a hydrophobic coating 1102A and 1102B.

(D4) In some embodiments of any of D2-D3, the pogo pin includes grease to mitigate moisture intrusion. For example, Figure 11 illustrates that pogo pins 1100A and 1100B are coated with a hydrophobic coating 1102A and 1102B.

(D5) In some embodiments of any of D1-D4, the light and the clasp have a ring shape. For example, Figure 9 shows a ring portion 902 that has a ring shape.

(D6) In some embodiments of any of D1-D5, the clasp attaches to the other portion of the portable charging case via a magnet. In some embodiments, the portion of the clasp located on the lid is made of a ferrous material that couples with magnets embedded in the other portion of the charging case, or vice versa. In some embodiments, a plurality of magnets are used on the other portion. In some embodiments, magnets are used on both the portion of the clasp located on lid and the other portion, and can use multiple magnets with different polarity orientations. For example, Figure 8 shows a few example of magnets being used to secure the lid portion to the other portion of the case (e.g., through magnets 814A-814B and/or magnet(s) 816 and a ferrous clasp 804).

(D7) In some embodiments of any D1-D7, the cavity is configured to house smart glasses of different shapes, where the smart glasses of different shapes have common fixed positions on their respective glasses frames to couple to a glasses-retention portion of the portable charging case. For example, Figure 10 shows certain portions of a pair of smart glasses remain fixed, but allow for variations in shape and size in non-fixed locations.

(D8) In some embodiments of D7, the common fixed positions are on each nose pad and nose bridge. For example, Figure 10 illustrates example locations in which a pair of smart glasses 1000 have fixed regions 1002, 1004, and 1006 that allow for the pair of smart glasses to interface (e.g., couple and receive a charge) with the portable charging case.

(D9) In some embodiments of any of D1-D8, the light ring is produced using a first shot of colored material, and a second shot of translucent material. For example, Figure 9 shows a first shot of material is provided to the surrounding areas 903 and then a second shot of material is provided to produce ring portion 902 which includes a location 910 for an LED.

(D10) In some embodiments of D9, titanium dioxide is added to the first shot of colored material to increase opacity of the material to avoid light leakage from the light into the first shot of colored material. In some embodiments, titanium dioxide is only needed for lighter colors, such as brown, as opposed to black. Figure 9 shows surrounding areas 903 having a different color than light ring 902.

(D11) In some embodiments of D1-D10, the titanium dioxide is .1-5% by volume (or mass) of the first shot. In some embodiments, the titanium dioxide is 3-5% by volume or mass of the first shot of material. In some embodiments, the titanium dioxide is 0.3-0.5% by volume or mass of the first shot of material.

(D12) In some embodiments of any of D1-D11, the light ring is produced via a light pipe that is illuminated by a multi-color LED. The light pipe is produced from the second shot of material and allows for an LED or multiple LEDs to be inserted into the light pipe. For example, Figure 9 shows a cavity 910 that is configured to house a LED.

(D13) The portable charging case of claim 1, the clasp is color matched to the color of the portable charging case. For example, a brown case will have a first shot that is also brown, or a black case will have a first shot that is black.

(E1) In accordance with some embodiments, a method of manufacturing a clasp of a portable glasses charging case comprises shooting a first shot of plastic that has a first opacity with an inner portion and outer portion. The method of manufacturing also includes, shooting a second shot of plastic between the inner portion and outer portion of the first shot with a second opacity to produce a clasp with a light pipe with a ring shape, and the first opacity is higher than the second opacity. Then the method of manufacturing comprises, providing an LED that is configured to transmit light through the light pipe. For example. Figure 8 shows a clasp produced using this method.

Figures 8A-11 and the additional details provided above are meant to complement the features of 1A- 5D and the features of 1A-5D are combinable with the features of 8A-11, and vice versa. D1-E1 are also meant to complement the features described in A1-C1, and vice versa.

Any data collection performed by the devices described herein and/or any devices configured to perform or cause the performance of the different embodiments described above in reference to any of the Figures, hereinafter the "devices," is done with user consent and in a manner that is consistent with all applicable privacy laws. Users are given options to allow the devices to collect data, as well as the option to limit or deny collection of data by the devices. A user is able to opt in or opt out of any data collection at any time. Further, users are given the option to request the removal of any collected data.

It will be understood that, although the terms "first," "second," etc., may be used herein to describe various elements, these elements should not be limited by these terms. These terms are only used to distinguish one element from another.

The terminology used herein is for the purpose of describing particular embodiments only and is not intended to be limiting of the claims. As used in the description of the embodiments and the appended claims, the singular forms "a," "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if' can be construed to mean "when" or "upon" or "in response to determining" or "in accordance with a determination" or "in response to detecting," that a stated condition precedent is true, depending on the context. Similarly, the phrase "if it is determined [that a stated condition precedent is true]" or "if [a stated condition precedent is true]" or "when [a stated condition precedent is true]" can be construed to mean "upon determining" or "in response to determining" or "in accordance with a determination" or "upon detecting" or "in response to detecting" that the stated condition precedent is true, depending on the context.

The foregoing description, for purpose of explanation, has been described with reference to specific embodiments. However, the illustrative discussions above are not intended to be exhaustive or to limit the claims to the precise forms disclosed. Many modifications and variations are possible in view of the above teachings. The embodiments were chosen and described in order to best explain principles of operation and practical applications, to thereby enable others skilled in the art.

## Claims

1. A portable charging case for smart glasses, the portable charging case comprising:
a glasses-retention portion of the portable charging case defining an interior surface of the portable charging case, wherein the glasses-retention portion is configured to apply a resistance force to securely hold smart glasses along the interior surface, and
a glasses-retention bracket, coupled with the glasses-retention portion, configured to apply a force to a nose pad of the smart glasses to hold the smart glasses in place to facilitate stable charging between electrical contacts of the portable charging case and other electrical contacts on the nose pad of the smart glasses.

2. The portable charging case of claim 1, wherein the electrical contacts of the charging case are pogo pins, wherein the pogo pins are configured to maintain an electrical connection with the electrical contacts on the smart glasses.

3. The portable charging case of claim 1 or claim 2, wherein the glasses-retention bracket is a cylindrical bar.

4. The portable charging case of any preceding claim, wherein the glasses-retention bracket has a rounded rectangular surface.

5. The portable charging case of any one of claims 1 to 3, wherein the glasses-retention bracket has a triangular surface.

6. The portable charging case of any preceding claim, wherein the glasses-retention bracket comprises one or more deployable portions configured to apply a resistance force to securely hold smart glasses along the interior surface.

7. The portable charging case of any preceding claim, wherein the glasses-retention portion comprises a portion of the portable charging case that is configured to deflect, and upon deflection applies the resistance force to securely hold the smart glasses.

8. The portable charging case of any preceding claim, wherein the glasses-retention portion comprises a coil spring or a torsion spring.

9. The portable charging case of any one of claims 1 to 7, wherein the glasses-retention portion comprises a leaf spring;
optionally wherein the leaf spring is made of a sheet metal material or a polymer material;
optionally, wherein the leaf spring comprises a magnet configured to adjust a bending force of the leaf spring.

10. The portable charging case of claim 9, wherein the leaf spring has a non-linear shape along an axis;
optionally, wherein the leaf spring has a non-linear shape along another axis.

11. The portable charging case of any preceding claim, wherein a release mechanism configured to release the smart glasses from the charging case.

12. The portable charging case of any preceding claim, wherein the glasses-retention portion and the retention bracket are coupled together.

13. The portable charging case of any preceding claim, wherein the glasses-retention portion is a separate structure and not integrally formed with rest of the portable charging case.

14. The portable charging case of any preceding claim, wherein the charging case comprises a battery that is configured to charge another battery located within the smart glasses, wherein the battery is configured to charge the other battery at least once.

15. The portable charging case of any preceding claim, wherein an exterior surface of the portable charging case has a laminated cosmetic covering.
